Europäisches Patentamt

(19) European Patent Office

Office européen des brevets

(11) Publication number: **0 461 867 A2**

(12) **EUROPEAN PATENT APPLICATION**

(21) Application number: **91305281.7**

(22) Date of filing: **12.06.91**

(51) Int. Cl.⁵: **H01L 29/66**

(30) Priority: **13.06.90 JP 154252/90**
**31.08.90 JP 231508/90**

(43) Date of publication of application:
**18.12.91 Bulletin 91/51**

(84) Designated Contracting States:
**DE FR GB**

(71) Applicant: **FUJITSU LIMITED**
**1015, Kamikodanaka Nakahara-ku**
**Kawasaki-shi Kanagawa 211 (JP)**

(72) Inventor: **Schmidt, Poul Erik**
**2 Residence la Vaucouleur**
**F-91940 Les Ulis (FR)**
Inventor: **Yokoyama, Noaki**
**1-11-3-326, Tsumadahigashi**
**Atsugi-shi, Kanagawa, 243 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

(54) Quantum electron device based on refraction of electron waves.

(57) A quantum wave device comprises a medium (100) for transporting carriers in the form of a two-dimensional carrier gas confined in a plane, an emitter electrode (120) provided on the medium, a collector electrode (122) provided on the medium with a separation from the emitter electrode, a first barrier structure (126) provided on the medium between the emitter and collector electrodes, a second barrier structure (130) provided on the medium between the first barrier structure and the collector electrode with a separation from the first barrier structure, a first quantum point contact (128') provided in the first barrier structure for passing the carriers therethrough in the form of a quantum mechanical wave, a second quantum point contact (132a', 132b') provided in the second barrier structure for passing the carriers therethrough in the form of a quantum mechanical wave, and a refraction structure (134) provided on the medium between the first and second barrier structures to intercept the quantum mechanical wave of the carrier produced by the first quantum point contact, wherein the refraction structure is applied with a control voltage signal and causes a refraction in the quantum mechanical wave of the carrier in response to the control voltage signal such that the quantum mechanical wave hits the second quantum point contact when the control voltage assumes a first voltage level and such that the quantum mechanical wave misses the second quantum point contact when the control voltage assumes a second voltage level.

EP 0 461 867 A2

# FIG. 4

## BACKGROUND OF THE INVENTION

The present invention generally relates to quantum electron devices and more particularly to a quantum electron device that operates on the basis of refraction of a quantum mechanical electron wave.

Conventional integrated circuits generally employ the bipolar transistors or MOS transistors for the signal amplification or switching. Particularly, the high electron mobility transistors (HEMT) or metal semiconductor field effect transistors (MESFET) that employ the high electron mobility of the compound semiconductor materials are characterized by the high operational speed and are used in various integrated circuits designed to operate in the microwave frequency range.

In order to fully exploit the excellent high speed performance of these devices, efforts are made to fabricate the integrated circuits with increased integration density. Such an effort includes the development of submicron patterning technique for writing a device pattern on a semiconductor wafer with the pattern width that is substantially smaller than 1 μm. With the progress of the submicron patterning technique, semiconductor devices having a size of a few microns or less are now becoming available.

In such submicron devices, although the integration density is increased for increased operational speed, the behavior of electrons in the form of electron waves appears strongly and the normal bipolar or MOS operation of the device, that assumes the electrons behave as particles, may be deteriorated, for example by the diffraction or interference of the electron waves.

On the other hand, there is proposed a device called electron wave device that assumes the wave nature of electrons for the basis of operation. In such electron wave devices, the electron waves are used positively for the device operation and because of this, the device is free from the problem of excessive miniaturization that has caused the problem in the conventional type semiconductor devices. In fact, the electron wave devices can be miniaturized without theoretical limitation, and the device is potentially capable of providing a superior performance to the conventional semiconductor devices with respect to the integration density, operational speed, and the like.

The inventors of the present invention have previously proposed a quantum interference semiconductor device that falls into the category of the electron wave device in the United States patent application S.N. 4,73,167 and European patent application EP 90 400 299.5 based on the Japanese patent applications 1-26213, 1-46939, 1-54521, 1-54522 and 1-52523 that are incorporated herein as reference.

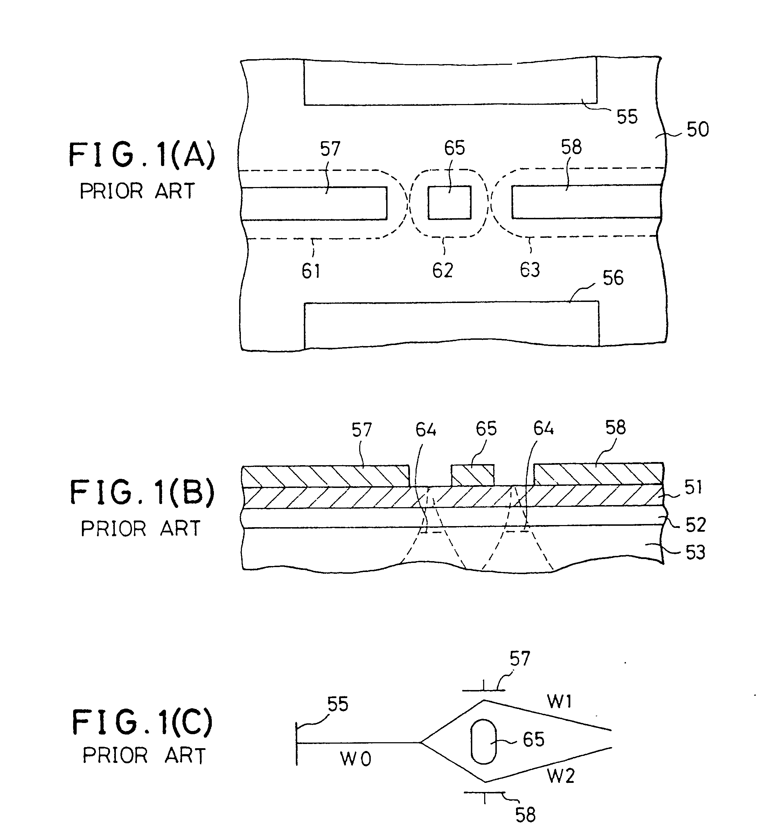

FIGS.1(A) - 1(C) show the quantum interference semiconductor device disclosed in the foregoing references. This prior art device has a pair of quantum point contacts for splitting an incident electron wave to a pair of electron waves, and the electron waves experience a phase shift upon passage through the respective quantum point contacts. Upon merging again, the electron waves interfere with each other and produces an output current. The quantum point contact herein means a one-dimensionally confined region for connecting a first region wherein the electrons form a two-dimensional electron gas and a second region wherein the electrons also form a two-dimensional electron gas. The quantum point contact is confined to have a width such that a number of discrete quantum levels are formed therein and has a limited length that is approximately equal to or smaller than the elastic or inelastic scattering length of the electrons.

When an electron wave enters into such a quantum point contact, the electron wave experiences a shift in the phase in correspondence to the quantum level formed in the quantum point contact. The prior art electron wave device controls the quantum level of the respective quantum point contacts for controlling the mutual phase difference of the electron waves. The device is turned on when the two electron waves form a constructive interference while turned off when the two electron waves form a destructive interference.

Referring to FIGS.1(A) and 1(B), this prior art electron device is formed upon a layered semiconductor body 50 in which a two-dimensional electron gas is formed. The layered semiconductor body 50 includes an $n^+$-type AlGaAs doped layer 51 for supplying electrons and an undoped GaAs channel layer 53, with an intervening undoped AlGaAs spacer layer 52 as usual. In this structure, the foregoing two-dimensional electron gas is formed along an upper boundary of the channel layer 53 in correspondence to the heterojunction between the AlGaAs layer having a large band gap and the GaAs layer having a smaller band gap, as is well known in the HEMT structure.

Similar to the usual HEMT, there is provided a source electrode 55 and a drain electrode 56 on the doped AlGaAs layer 51 with an ohmic contact to the layer 51, and the source electrode 55 injects the electrons into the two-dimensional electron gas while the drain electrode 56 recovers the electrons from the two-dimensional electron gas. In the region of the layer 51 formed between the source electrode 55 and the drain electrode 56, there are provided Schottky electrodes 57 and 58 to interrupt the flow of electrons from the source electrode 55 to the drain electrode 56 such that the Schottky electrode 57 is separated from the Schottky electrode 58 by a gap, and there is provided another Schottky electrode 65 in correspondence to the gap between the electrodes 57 and 58.

In this structure, it will be understood that there are formed a pair of passages of electrons, one between the electrode 57 and the electrode 65, and the other between the electrode 58 and the electrode 65. These passages, however, are confined laterally when viewed in the direction of the flow of electrons, as shown in FIG.1(B), due to the depletion regions 61, 62 and 63 formed under the electrodes 57, 58 and 65. Thereby, there appear discrete quantum levels in each of the passages when the width of the passage is confined substantially smaller than the de Broglie length of the electron waves. Further, each of the electrodes 57, 58 and 65 has a thickness in the propagating direction of the electron waves such that the thickness is typically 1 - 2 μm or less that is smaller than any of the elastic and inelastic scattering length of the electrons. Thereby, it will be understood that these passages form the quantum point contact defined before.

When a single electron is injected by the source electrode 55, the electron, represented by the electron wave W0, passes through the quantum point contacts as the electron waves W1 and W2 as shown in FIG.1(C), wherein the electron waves W1 and W2 represent the probability of the electron passing the respective channels. Upon passage through the quantum point contacts, the electron waves W1 and W2 merge with each other and cause the interference as described previously.

In this prior art device, there is a problem in that the interference tends to be obscured due to the variation in the energy level of the electrons that are injected, particularly when a large number of electrons are successively injected into the quantum point contacts. Such a variation in the energy of electrons occurs easily by the thermal agitation wherein the electrons exchange energy and momentum with phonons.

SUMMARY OF THE INVENTION

Accordingly it is an object of the present invention to provide a novel and useful electron wave device based upon a novel principle.

Another and more specific object of the present invention is to provide an electron wave device that utilizes the refraction of electron waves for the switching operation.

Another object of the present invention is to provide an electron wave device comprising a layered semiconductor body for forming a two-dimensional carrier gas therein, an emitter provided on the layered semiconductor body for injecting carriers into the two-dimensional carrier gas, a collector provided on the layered semiconductor body with a separation from the emitter for collecting the carriers from the two-dimensional carrier gas, a first barrier structure provided on the layered semiconductor body between the emitter and collector for interrupting the two-dimensional carrier gas in correspondence thereto, a quantum point contact provided in the first barrier structure as a confined passage of carriers moving from a first side of the first barrier structure that faces the emitter to a second, opposite side thereof that faces away from the emitter, said passage having a width so confined that one or more quantum levels of the carriers are formed in the quantum point contact, said passage being further confined to have a length, measured in a direction connecting the emitter and the collector, of equal to or smaller than any of the elastic and inelastic scattering lengths of the electrons that form the two-dimensional carrier gas, said quantum point contact injecting the carriers into the second side as a quantum mechanical wave having predetermined directivity, a second barrier structure provided on the layered semiconductor body between the first barrier structure and the collector for interrupting the two-dimensional carrier gas in correspondence thereto, a passage of carriers provided in the second barrier structure for allowing a passage of the carriers through the second barrier structure, and a refractive structure provided between the first and second barrier structures for refracting the quantum mechanical wave of the carriers passing therethrough. According to the present invention, a reliable switching operation of the device is obtained by deflecting the directional electron wave that is produced by the quantum point contact and injected into the second side of the first barrier structure. The deflection of the electron wave is achieved by refraction upon passage of the electron wave above a potential that is induced by the refractive structure in response to a control voltage applied thereto. Under the control of the refractive structure, the electron wave is refracted and hits the passage of carriers formed in the second barrier structure when the device is turned on, and an output current is detected at the collector. When the device is turned off, on the other hand, the directional electron wave misses the passage and no output is obtained at the collector. Thereby, a reliable switching is achieved with extremely high speed.

Other objects and further features of the present invention will become apparent from the following detailed description when read in conjunction with the attached drawings.

BRIEF DESCRIPTION OF THE DRAWINGS

FIGS.1(A) - 1(C) are diagrams showing the conventional electron wave device wherein the device is turned on and turned off in response to the interference of quantum mechanical electron waves;

FIGS.2(A) - 2(D) are diagrams showing the principle of the present invention;

FIGS.3(A) - 3(G) are diagrams for explaining the experiment that forms the basis of the present invention;

FIG.4 is a plan view showing a first embodiment of the present invention;

FIGS.5(A) - 5(C) are diagrams showing the layered structure of the device of FIG.4 along various cross sections;

FIG.6 is a plan view similar to FIG.4 showing the definition of various parameters of the device of the present invention as well as the electric biasing for the operation of the device;

FIG.7 is an enlarged view showing a part of the device of FIG.4 or FIG.6 in the plan view for explaining the refraction of the electron wave in the device;

FIG.8 is a diagram for explaining the principle of the refraction of the electron wave in the device of FIG.6;

FIG.9 is an enlarged view showing a modification of the first embodiment device;

FIGS.10(A) - 10(D) are diagrams showing the fabrication process of the device of the first embodiment;

FIG.11 is a plan view showing a second embodiment of the present invention;

FIG.12 is an enlarged view showing a part of FIG.11 for explaining the principle of the second embodiment;

FIG.13 is a diagram similar to FIG.11 showing the biasing of the device of FIG.11;

FIG.14 is a graph showing an example of operation of the device of FIG.13;

FIGS.15(A) and 15(B) are diagrams respectively showing the plan view and the operational characteristic of a third embodiment of the present invention;

FIGS.16(A) - 16(C) are diagrams showing a fourth embodiment of the present invention; and

FIGS.17(A) and 17(B) are diagrams showing a fifth embodiment of the present invention.

## DETAILED DESCRIPTION

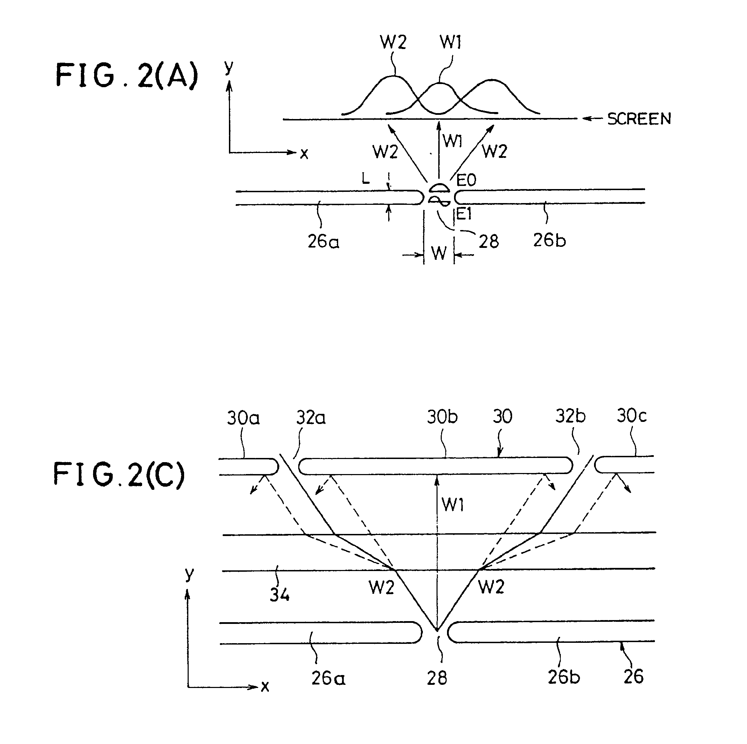

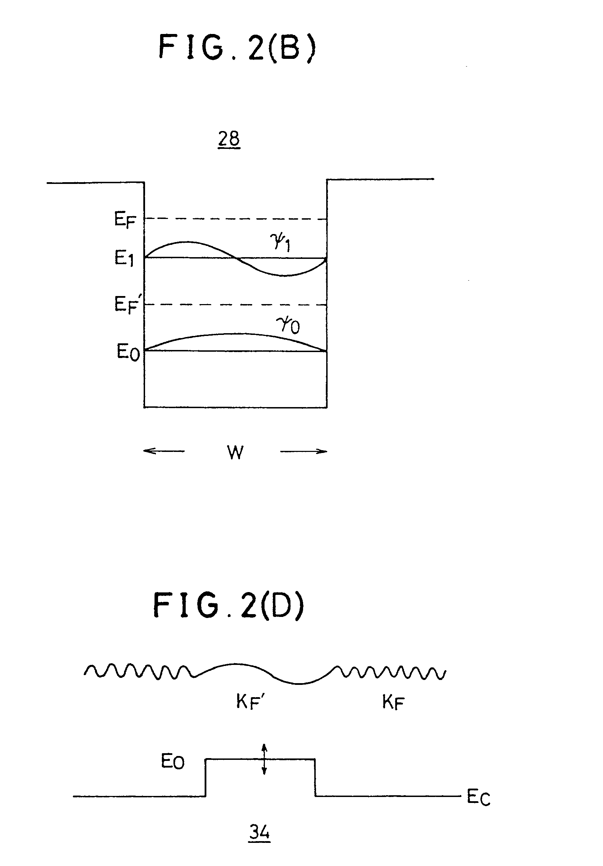

First, the principle of the present invention will be described with reference to FIG.2(A) - 2(D), wherein FIGS.2(A) and 2(C) are the plan views of a structure in which a two-dimensional electron gas is formed.

Referring to FIG.2(A), this diagram shows the discrete quantum levels E0 and E1 that are formed in a quantum point contact 28 that in turn is formed between a pair of elongated depletion regions 26a and 26b as a passage of the electron wave. Here, the elongated depletion regions 26a and 26b are aligned in the x-direction and rejects the penetration of electrons. Thereby, the two-dimensional electron gas that is formed in the plane parallel to the sheet of the drawing is interrupted in correspondence to the depletion regions 26a and 26b. As already described, the quantum point contact 28 has a limited lateral size W that is sufficiently confined to form discrete quantum levels E0, E1,. . . for the electrons that pass through the quantum point contact 28.

FIG.2(B) shows the band diagram of the quantum point contact 28, wherein the foregoing quantum levels $E_0$, $E_1$ ($E_0 < E_1$) and associated wave functions $\psi_0$ and $\psi_1$ are shown.

The quantum level $E_0$ corresponds to the ground level, and the wave function $\psi_0$ for the level $E_0$ does not include a node in which the sign of the wave function changes. Such a pattern of the wave function indicates that there is no lateral component in the momentum of the electron wave having the energy $E_0$, and the electron wave of this mode exits from the quantum point contact 28 straight in the direction shown in FIG.2(A) by W1. For example, when an electron wave having the energy corresponding to the Fermi level of $E_F'$ has entered into the quantum point contact 28, the electron wave has the wave vector or momentum $k_{W1}$ only in the x-direction that is represented as

$$k_{W1} = [2m\hbar(E_{F'} - E_0)]^{\frac{1}{2}}$$

where m represents the mass of the electron and $\hbar$ represents the Planck's constant divided by $2\pi$.

On the other hand, the wave function $\psi_1$ for the higher mode does include such a node, and there appears a lateral component in the momentum of the electron wave. For example, when an electron wave having an energy corresponding to the Fermi level $E_F$ has entered into the quantum point contact 28, the momentum $k_X$ of the electron wave in the x-direction that is parallel to the depletion regions 26a and 26b, is represented as

$$k_X = [2m\hbar(E_F - E_1)]^{\frac{1}{2}},$$

while the momentum in the y-direction is represented as

$$k_Y = [2m\hbar(E_1 - E_0)]^{\frac{1}{2}}.$$

Thereby, the electron wave exits from the quantum point contact 28 in a direction W2 that is defined by the sum of the wave vectors $k_X$ and $k_Y$. There are two equivalent directions W2 about the y-axis, and the electron wave thus exited from the quantum point contact 28 propagates in the W2 direction as indicated in FIG.2(A) with a sharp directivity. Once exited, the electron wave resumes the original magnitude of the wave vector $k_F$ in the traveling direction. When a hypothetical screen for detecting the electrons is provided as illustrated, a pattern as shown by W2 would have been observed for the electron wave for the mode $E_1$, in addition to the pattern W1 corresponding to the electron wave in the mode $E_0$.

FIG.2(C) shows the principle of the electron wave device that employs the foregoing radiation pattern of the electron waves produced by the quantum point contact. This drawing also shows a plan view in which the two-dimensional electron gas is formed in the plane coincident to the sheet of the drawing.

In this electron wave device, the depletion regions 26a and 26b form a first barrier structure 26, while there is provided a second barrier structure 30 including elongated depletion regions 30a, 30b and 30c such that the depletion regions 30a, 30b and 30c are aligned in the x-direction. In the second barrier structure 30, there are formed passages 32a and 32b of electrons respectively between the depletion regions 30a and 30b and between the depletion regions 30b and 30c. The depletion regions 26a and 26b oppose the depletion regions 30a, 30b and 30c as illustrated, and there is provided a refractive structure 34 between the first and second barriers such that the structure 34 causes a refraction of the electron waves, particularly in the electron wave W2 that enters into the structure 34 obliquely, by inducing a modified potential level as shown in FIG.2(D).

FIG.2(D) shows the potential $E_\phi$ induced by the refractive structure 34. This drawing illustrates the energetical cross section taken along the path of the electron wave W1. As can be seen, there is formed a potential rise having the energy $E_\phi$ in the conduction band Ec in correspondence to the structure 34, and such an energy rise induces a variation in the wave vector of the electron waves that enters the structure 34 with the Fermi energy $E_F$ as

$$k_{F'} = [2m(E_F - E_\phi)^{i/}\hbar.$$

By controlling the energy level $E_\phi$, one can modify the wave vector $k_{F'}$ of the electron wave passing through the structure 34. Upon exiting from the structure 34, the electron wave resumes the original wave vector $k_F$.

Considering now the case in which the electron wave W2 enters into the structure 34 obliquely with the wave vector $k_F$ in the propagating direction in correspondence to the Fermi energy $E_F$, the y-component of the wave vector, $k_{Fy}$, experiences the foregoing variation of the electron wave and the velocity of the electron wave changes in response thereto similar to the case of a light entering into a medium having a higher velocity. On the other hand, the x-component of the wave vector, $k_{Fx}$, remains uninfluenced and the electron wave W2 experiences a refraction similar to the refraction of light. By controlling the energy level $E_\phi$, the "refractive index" of the structure 34 is changed as desired, and the path of the electron wave W2 is changed as shown by the broken lines in FIG.2(C). Upon exiting from the refractive structure 34, the electron wave W2 resumes the original direction of propagation. Thereby, the path of the electron wave W2 is shifted parallel with respect to the original path, depending on the refractive index.

When the energy level $E_\phi$ is selected suitably, the electron wave W2 passes through one or both of the passages 32a and 32b and the current corresponding to the electron wave W2 is detected. This state corresponds to the turned-on state of the electron wave device. On the other hand, when the energy level $E_\phi$ is set such that the electron wave W2 is blocked at the second barrier structure 30, the device is turned off, producing no output current.

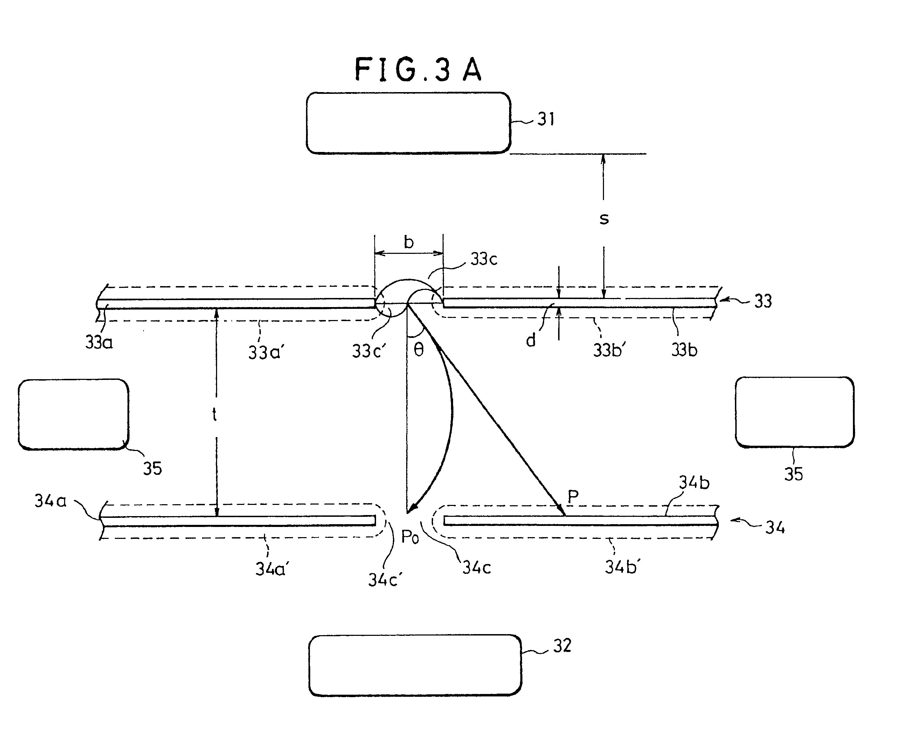

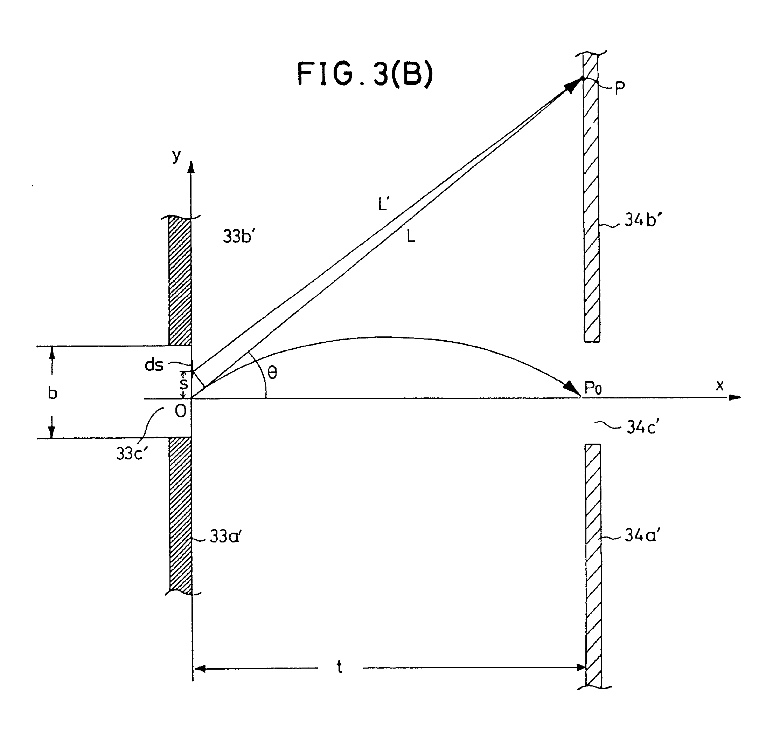

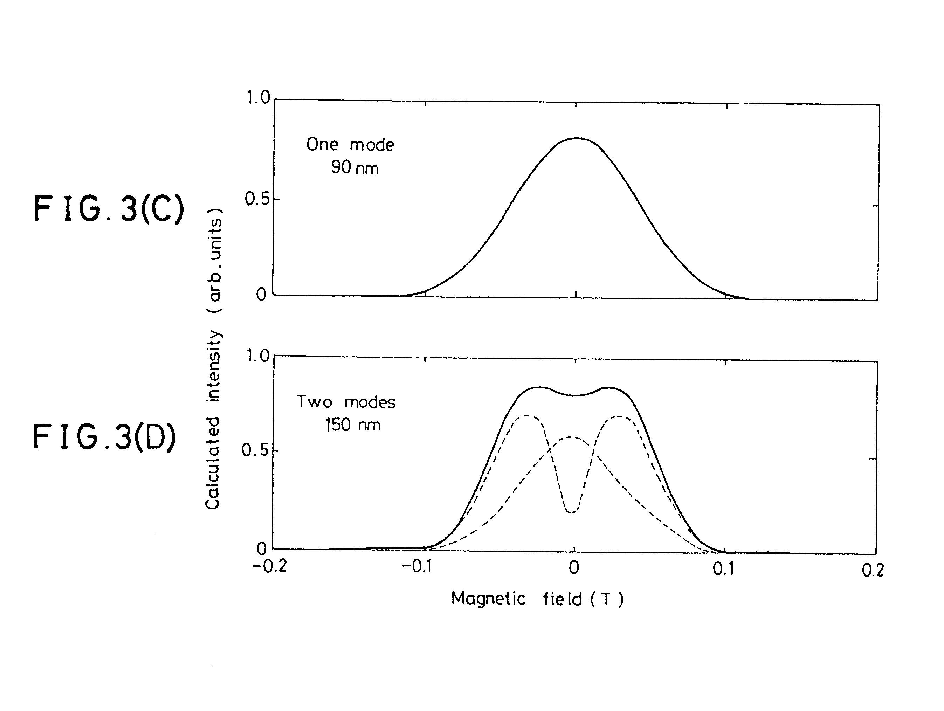

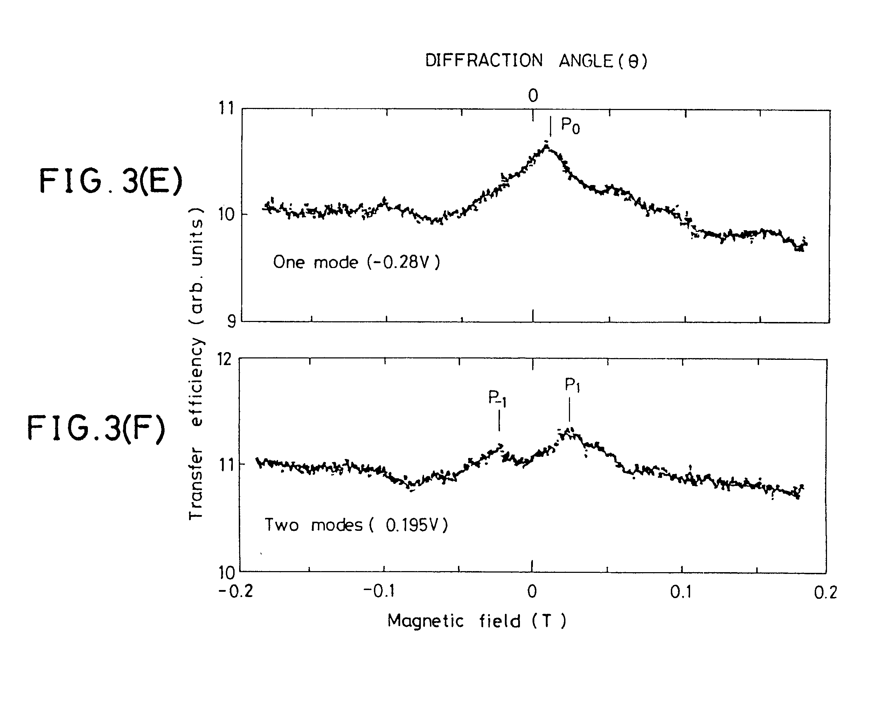

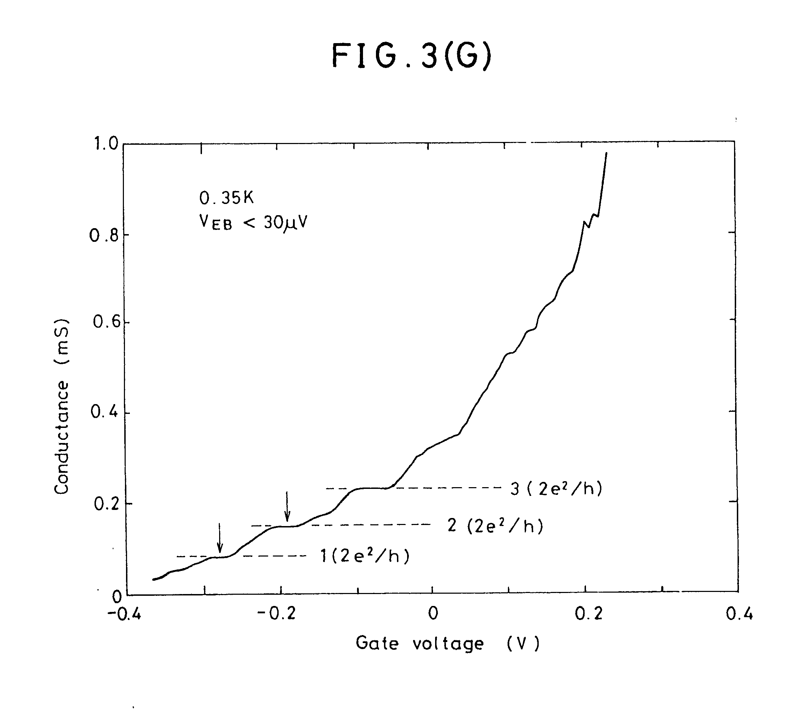

Next, the experiment that demonstrates the directive radiation pattern associated with the quantum point contact will be described with reference to FIGS.3(A) - 3(G).

FIG.3(A) shows the plan view of a device that is employed for the experiment. The device is constructed on a layered semiconductor body that includes an MBE-grown GaAs/AlGaAs modulation-doped heterostructure. More specifically, the layered semiconductor body includes an undoped GaAs channel layer, an undoped $Al_{0.3}Ga_{0.7}As$ spacer layer grown on the GaAs channel layer with a thickness of 20 nm, and an n-type $Al_{0.3}Ga_{0.7}As$ layer doped to a carrier concentration level of $1.4 \times 10^{18} cm^{-3}$ and grown on the AlGaAs spacer layer with a thickness of 50nm. On the doped AlGaAs layer, an $n^+$-type GaAs cap layer is grown with a thickness of 50 nm. The carrier density of the GaAs cap layer is set to $1.4 \times 10^{18} cm^{-3}$. In this layered semiconductor body, a two-dimensional electron gas is formed with the carrier concentration of $3.5 \times 10^{11} cm^{-2}$. The two-dimensional electron gas has the mobility of $3 \times 10^5 cm^2/V \cdot s$ at 1.2 °K that provides the mean free path exceeding 1 μm. Within the length of the mean free path, the electrons move ballistically in correspondence to the scatter-free transport of electrons. The electrons in the two-dimensional electron gas thus formed has the Fermi wavelength of 42 nm. The plan view of FIG.3(A) shows the top surface of the n-type AlGaAs layer.

On the top surface of the n-type AlGaAs layer, there is provided an emitter electrode 31 and a collector electrode respectively in ohmic contact to the n-type AlGaAs layer, and a first barrier structure 33 that includes elongated Schottky electrodes 33a and 33b is provided such that the electrodes 33a and 33b are aligned in the x-direction. In correspondence to the Schottky electrodes 33a and 33b, depletion regions 33a' and 33b' are formed similarly to the depletion regions 26a and 26b of FIG.2(A). Between the Schottky electrodes 33a and 33b, a gap 33c is formed with a width b, and in correspondence to the gap 33c, there is formed a passage 33c' of electrons in the two-dimensional electron gas.

The Schottky electrodes 33a and 33b have a size d measured in the direction connecting the emitter and collector electrodes 31 and 32 in the plane parallel to the two-dimensional electron gas, such that the size d is set smaller than the elastic or inelastic scattering length of electrons in the two-dimensional electron gas. In the present experiment, the size d was set to 0.1 μm. On the other hand, the width b of the gap 33c was set to be 0.4 µm. Thereby, the passage 33c' forms a quantum point contact. The extension of the depletion regions 33a' and 33b' is controlled in response to the voltage applied to the Schottky electrodes 33a and 33b as usual, and in response to the extension of the depletion regions, the size of the quantum point contact 33c' is changed. The first barrier structure 33 is provided with a distance s from the emitter electrode 31, wherein the distance s was set to 10 µm in the experiment.

Between the first barrier structure 33 and the collector electrode 34, there is provided a second barrier structure 34 that includes elongated Schottky electrodes 34a and 34b aligned in the x-direction. Between the Schottky electrodes 34a and 34b, there is formed a gap 34c. The size of the Schottky electrodes 34a and 34b as well as the size of the gap 34c, are set identical with that of the first barrier structure 33. Thereby, depletion regions 34a' and 34b' are formed in correspondence to the Schottky electrodes 34a and 34b, and a passage 34c' is formed between the depletion regions 34a' and 34b' similar to the case of the first barrier structure 33. The first barrier structure and the second barrier structure are disposed with a mutual distance t that was set to 1 µm in the experiment.

Between the first and second barrier structures 33 and 34, a base electrode 35 is provided in ohmic contact with the n+-type GaAs contact layer for applying a predetermined bias voltage. Thereby electrons are introduced into the quantum point contact 33c' by a potential difference induced in the two-dimensional electron gas across the first barrier structure 33. The base electrode 35 is also used for collecting the electrons that have been introduced into the region between the first and second barrier structures via the quantum point contact 33c' and failed to escape through the quantum point contact 34c'.

In order to evaluate the radiation pattern of electron wave emitted from the quantum point contact 33c', a diffraction pattern caused in the electron wave by the Fraunhofer diffraction is calculated.

Referring to FIG.3(B) showing the definition of coordinates and parameters, the contribution of a line element ds in the passage 33c' on the differential amplitude dUs of the electron wave at an arbitrary point P is given by

$$dUs = A \cdot ds/L \cdot \sin(\omega t - k_F(x + \Delta)) \quad (1)$$

where A is a constant, L represents the distance between the point P and an origin O that is set in the quantum point contact 33c', $k_F$ the Fermi wave vector of the electron in the two-dimensional electron gas, and _ represents the difference in the path lengths L and L' defined in FIG.3(B). Here, the path length L represents the distance between the line element ds and the point P while the path length L' represents the distance between the origin O and the point P. From the primitive geometry, it will be seen that there holds a relationship

$$\Delta = s \cdot \sin \theta,$$

where θ represents the coordinate of the point P represented in the polar coordinate (L, θ) with respect to the origin O. By integrating the differential amplitude dUs for the entire width b of the passage 33c, one obtains the angular distribution of the intensity of the electron wave at an arbitrary point P as

$$U(\theta) = \int_{-b/2}^{+b/2} A \cdot ds/L \cdot \sin [\omega t - k(x + \Delta)] \quad (2)$$

wherein the parameter A is given for the mode W1 of FIG.2(A) as

$$A = a \cdot \cos (\pi/b \cdot s), \quad a = \text{constant}, \quad (3)$$

while the same parameter A is given as

$$A = a \cdot \sin (2\pi/b \cdot s), \quad a = \text{constant} \quad (4)$$

for the mode W2 of the electron wave. See the form of the wave functions $\psi_0$ and $\psi_1$ of FIG.2(B).

Thereby, a diffraction pattern of the electron wave shown in FIGS.3(C) and 3(D) is expected to appear on the second barrier structure 34 according to the foregoing Eq.(2), wherein FIG.3(C) shows the expected pattern for the electron wave W1 while FIG.3(D) shows the expected pattern for the superposition of the electron waves W1 and W2. The difference between the diffraction pattern of FIG.3(C) and that of FIG.3(D) arises from the different representation of the parameter A used in Eq.(2).

In order to detect or demonstrate the expected diffraction of the electron waves, a magnetic field T is applied to the device such that the magnetic field T penetrates perpendicular to the two-dimensional electron gas. By doing so, the path of the electron wave is curved due to the Lorentz force acting on the electron, and one can detect the electrons exiting through the passage 34c' at the point Po when the magnitude of the magnetic field is adjusted appropriately. Alternatively, one can observe the diffraction pattern as a function of the intensity of the magnetic field T when the magnetic field intensity is changed continuously.

FIGS.3(E) and 3(F) show the result of the experiment that was conducted by using the device of FIG.3(A) for observing the diffraction pattern of the electron wave. In the experiment, a gate voltage of -0.28 volts or -0.195 volts was applied to the Schottky electrodes 33a and 33b respectively in correspondence to the formation of the electron wave W1 and the formation of the electron waves W1 and W2. The reason why these gate voltages were chosen will be discussed later. In order to introduce the electron waves into the quantum point contact 33c', a bias voltage of 30 μV was applied across the emitter and the base electrodes. The measurement was conducted at a temperature of 0.35 °K while changing the strength B of the magnetic field T from -0.2 Tesla to + 0.2 Tesla. It should be noted that the strength B of the magnetic field T is converted to the diffraction angle θ by the equation

$$k \cdot s \cdot \sin\theta = \pi e/h \cdot B \cdot s \cdot t \quad (5)$$

where t represents the distance t between the first and second barrier structures 33 and 34 as defined in FIG.3(A).

As can be seen clearly in FIG.3(E), there appears a single peak $P_0$ in the current detected by the collector electrode 32 in correspondence to the electrons exiting through the detector quantum point contact 34c'. From the reason to be described, it is identified that the peak $P_0$ corresponds to the peak of FIG.3(C) for the electron wave W1. The pattern of FIG.3(E) as a whole agrees to the pattern of the electron wave W1 for the case where the width b of the quantum point contact 33c', formed in the two-dimensional electron gas by the depletion regions 33a' and 33b', has the size of 90 nm.

In the pattern of FIG.3(F), two peaks, $P_{-1}$ and $P_1$, are observed. This pattern corresponds to the calculated pattern of FIG.3(D) where the electron waves W1 and W2 are superposed. The pattern of FIG.3(F) as a whole coincides to the calculated pattern for the case where the width b of the passage 33c' is set to 150 nm.

FIG.3(G) shows the conductance of the device of FIG.3(A) measured at 0.35 °K while applying the same base-emitter bias voltage. In this experiment, no magnetic field was applied. The conductance was measured for various gate voltages applied to the Schottky electrodes 33a and 33b.

As can be seen clearly in FIG.3(G), the conductance changes with the gate voltage in the stepped manner, wherein the first step has the conductance corresponding to $2e^2/h$, the second step has the conductance corresponding to $2 \times 2e^2/h$, the third step has the conductance corresponding to $3 \times 2e^2/h$, etc. This quantized relationship clearly indicates that the electrons behave as a quantum mechanical wave having discrete energy levels in the device of FIG.3(A). Particularly, by setting the gate voltage at -0.28 volts in correspondence to the first step, one can observe the electron wave W1 corresponding to the ground state $E_0$. When the gate voltage is set at -0.195 volts in correspondence to the second step of FIG.3(G), on the other hand, one can observe the electron wave W2 corresponding to the quantum state $E_1$.

The foregoing gate voltage of -0.28 volts or -0.195 volts used for the observation of the diffraction pattern, was selected based upon the observation of FIG.3(G). More particularly, when the gate voltage is set at -0.28 volts, the width W of FIG.2(B) corresponding to the size b of the quantum point contact 33c' is narrowed and the energetic separation between the quantum levels $E_0$ and $E_1$ increases. Thereby, the energy of the quantum level $E_1$ exceeds the Fermi energy $E_F$ of the two-dimensional electron gas incident to the passage 33c' and the electron wave for the incident electron can only take the mode W1. This situation is equivalent to the case where the incident electron has the Fermi level $E_F$ of FIG.2(B) relative to the energy $E_0$. On the other hand, when the gate voltage is set at -0.195 volts that is smaller in the magnitude than the former gate voltage of -0.28 volts, the width W of FIG.2(B) is increased, resulting the reduced energetical separation between the quantum levels $E_0$ and $E_1$. In this case, the Fermi energy $E_F$ exceeds the energy of the quantum level $E_1$ and the electron wave can assume the two modes, W1 and W2. In correspondence to this, the two peaks $P_{-1}$ and $P_1$ are observed in FIG.3(F).

In summary, the foregoing experiment clearly demonstrates that the electrons behave as the quantum mechanical wave in the quantum point contact and exits therefrom with a sharp directivity. Particularly, the electron wave W1 corresponding to the ground level $E_0$ of the quantum point contact exits straight in the direction perpendicular to the barrier structure in which the quantum point contact is formed, and propagates like a light beam. On the other hand, the electron wave W2 exits in the oblique direction to the barrier structure. As described previously, the present invention proposes an electron wave device wherein the turning-on and turning-off of the device is achieved in response to the refraction of the electron wave beam produced by the quantum point contact.

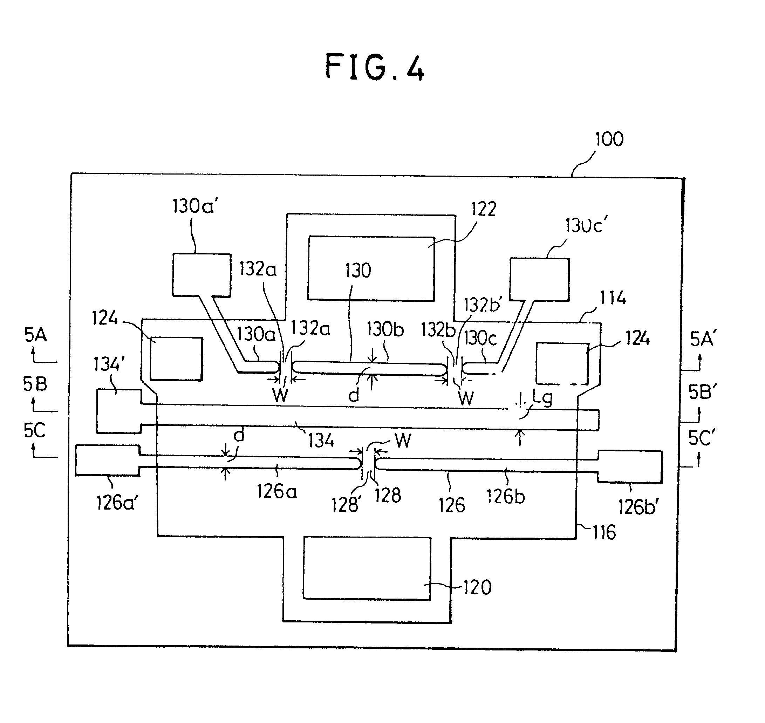

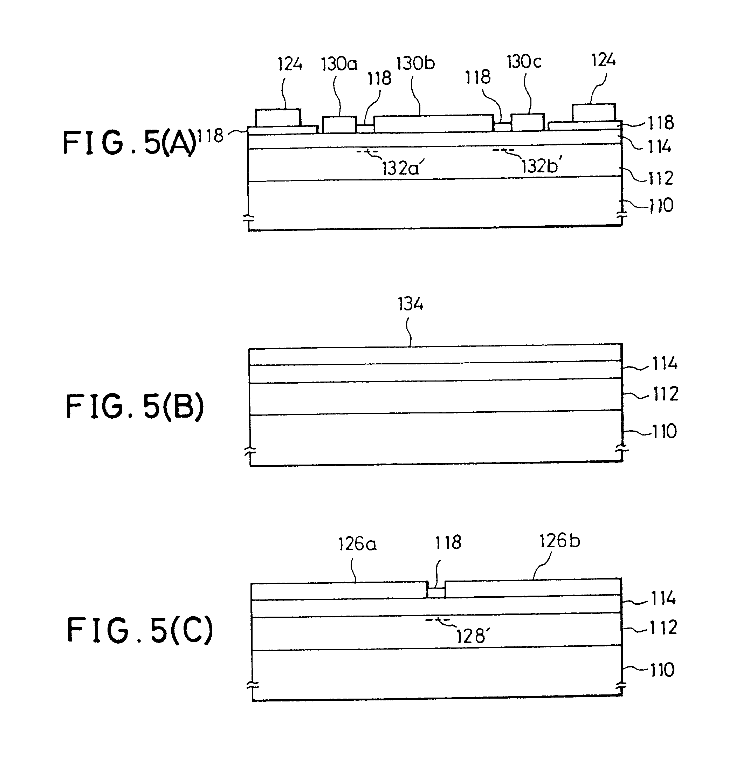

FIG.4 shows a first embodiment of the present invention in the plan view, and FIGS.5(A) - 5(C) show the elevational cross section thereof taken along various vertical sections.

Before describing the structure of FIG.4, reference is made to the cross section of FIGS.5(A) -5(C). Referring to FIGS.5(A) - 5(C), the electron wave device of FIG.4 is constructed on a layered semiconductor body 100 that includes a semi-insulating GaAs substrate 110 and an undoped GaAs active layer 112 grown on the substrate 110 epitaxially with a thickness of 500 nm. On the active layer 112, an n-type AlGaAs layer 114 doped with the carrier concentration level of $1.4 \times 10^{18} cm^{-3}$ is grown with a thickness of 45 nm. The active layer 112 and the doped layer 114 may be grown by the MBE process. Further, a contact layer of n-type GaAs is provided on the n-type AlGaAs layer 114 as usual in the HEMT structure.

The doped layer 114 is patterned as shown in FIG.4 together with the contact layer 118 thereon, wherein a two-dimensional electron gas is formed in correspondence to the patterned doped layer 114 at the interface between the active layer 112 and the doped layer 114. In the region of FIG.4 at the outside of the doped layer 114, the active layer 112 is exposed due to the absence of the layer 114, and the active layer corresponding to this part is made inactive by the ion implantation of deep impurities such as oxygen.

Referring now to FIG.4, an emitter electrode 120 and a collector electrode 122 are provided on the patterned contact layer 118 to form an ohmic contact therewith. Further, a first barrier structure 126 including Schottky electrodes 126a, 126b and 126c are provided on the doped AlGaAs layer 114 as illustrated, and a gap 128 is formed between the Schottky electrodes 126a and 126b with a width W. See the cross section of FIG.5(C) showing the cross section taken along the line 5C-5C'.

Each of the Schottky electrodes 126a and 126b has a layered structure of Ti/Pt/Au respectively with thicknesses of 30 nm, 50 nm and 200nm, and has a size d measured in the direction connecting the emitter and collector electrodes 120 and 122 in the plane parallel to the two-dimensional electron gas, such that the size d is about 0.1 μm that is substantially smaller than the elastic as well as the inelastic scattering lengths of electrons in the two-dimensional electron gas. On the other hand, the width W is typically set to a value of about 0.4 μm in view of the experiment described previously. Thereby, a quantum point contact 128' is formed in the two-dimensional electron gas in correspondence to the gap 128. The Schottky electrodes 126a and 126b respectively have contact pads 126a' and 126' at the region outside the n-type AlGaAs layer 114 for application of the gate voltage.

It should be noted that the size d of the barrier structure 126 is not limited to the foregoing value of 0.1 μm, but any other size may be possible as long as it is smaller than the elastic and the inelastic scattering length of the electrons, and as long as the barrier structure 126 functions as the effective barrier to the electrons. Similarly, the width W is not limited to 0.4 μm but any other width may be possible as long as the quantum well is formed in the active layer 112 in correspondence to the gap 128. Further, the effective width of the quantum well is controlled as desired in response to the gate voltage applied to the contact pads 126a' and 126b'.

In the vicinity of the collector electrode 122, there is provided a second barrier structure 130 that includes Schottky electrodes 130a, 130b and 130c. Each of these Schottky electrodes has a structure and size substantially identical with those of the first barrier structure 126 as illustrated, and gaps 132a and 132b are formed respectively between the electrodes 130a and 130b and between the electrodes 130b and 130c. The gaps 132a and 132b have a width W that is substantially identical with the width W of the gap 128. Thereby, a pair of quantum point contacts 132a' and 132b' similar to the one formed under the gap 128 are formed in the two-dimensional electron gas respectively in correspondence to the gaps 132a and 132b, and the electrons can exit through these quantum point contacts. See the cross section of FIG.5(A) taken along the line 5A-5A'. The actual size of the quantum point contacts corresponding to the gaps 132a and 132b is controlled in response to the control voltage applied to the electrodes 130a and 130b at respective contact pads 130a' and 130b'.

Between the barrier structure 126 and the barrier structure 130, there is provided another Schottky electrode 134 on the n-type AlGaAs layer 114 to extend generally parallel to the first and second barrier structures 126 and 130. The Schottky electrode 134 includes a layered structure of Ti/Pt/Au similar to the other Schottky electrodes and has a size Lg in the direction connecting the emitter 120 and the collector 122 of the device as shown in FIG.4. The Schottky electrode 134 has a connection pad region 134' and induces the potential $E_{\phi}$ of FIG.2(D) in response to a control voltage applied to the connection pad region 134'. Thereby, the electron wave that passes through the region under the electrode 134 experiences a change in the wave number and hence the change in the velocity. Associated therewith, the electron wave experiences a refraction upon passage through the region under the Schottky electrode 134. FIG.5(B) shows the cross-section taken along the line 5B-5B' for including the Schottky electrode 134.

Further, a pair of base electrodes 124 are provided on the contact layer 118 between the second barrier structure 130 and the Schottky electrode 134 for applying a suitable bias voltage between the emitter electrode 122 and the base electrode 124 across the barrier structure 130. The base electrodes 124 are provided generally symmetric with respect to a hypothetical center line C connecting the emitter electrode 120 and the collector electrode 122 and located close to the lateral edge of the patterned contact layer 118.

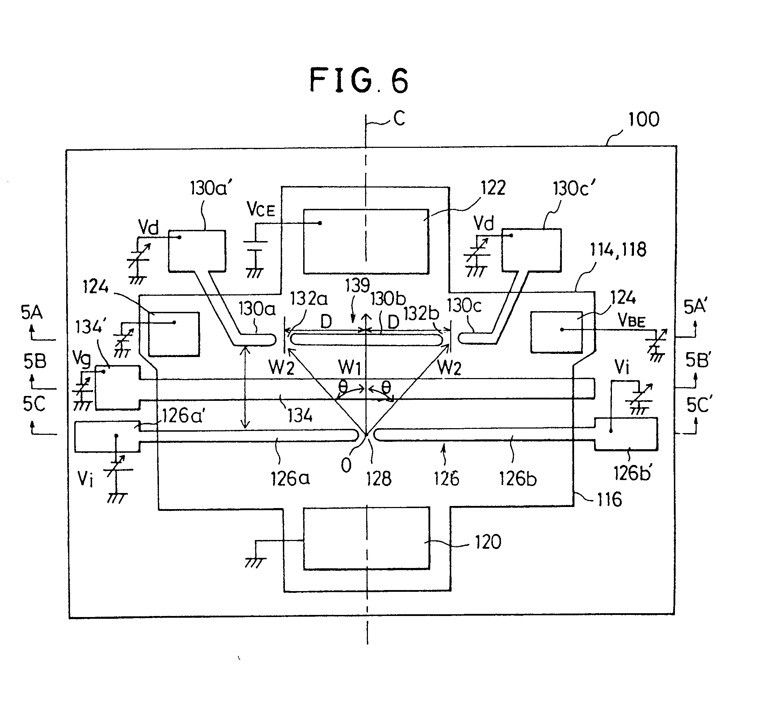

FIG.6 shows the setting of the Schottky electrodes in the first and second barrier structures to obtain the desired device operation.

Referring to FIG.6 showing the essentially same structure as FIG.4, the gaps 132a and 132b are provided symmetric with respect to the hypothetical center line C passing through the center O of the gap 128 and extending in the direction to connect the emitter and collector electrodes. This hypothetical center line C is substantially coincident to the passage of the electron wave W1 for the ground mode. As shown in FIG.6, the gaps 132a and 132b are provided symmetrical with respect to the center line C, with an equal distance D that is the shortest distance between the center line C and the center of the gap 132a or 132b.

The distance D is set such that the electron wave for the mode W2 hits the quantum point contact 132a' or 132b' formed under the gaps 132a or 132b, after passing through the potential induced by the Schottky electrode 134 in a first logic state of the electron wave device. For example, the distance D is determined such that the electron wave W2 enters straight into the quantum point contact 132a' or 132b' after exiting from the quantum point contact 128' when no control voltage is applied to the Schottky electrode 134. In this case, the distance D is determined as D = t·tanθ.

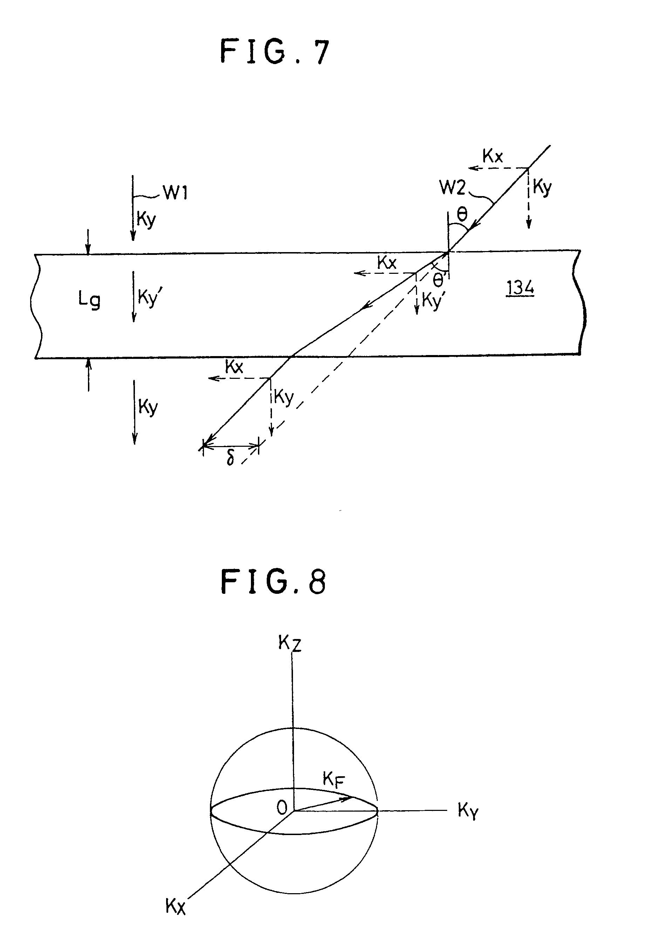

The width of the gaps 132a and 132b is set such that the electron wave W2 positively misses the quantum point contacts 132a' and 132b' when the control voltage is applied to the Schottky electrode 134. FIG.7 shows the refraction of electron wave caused by the Schottky electrode 134.

Referring to FIG.7, the electron wave W1 that enters into the region under the Schottky electrode 134 with the right angle experiences a change in the wave number from $k_Y$ to $k_{Y'}$. Upon exiting, the electron wave W1 resumes the original wave number $k_Y$. As the electron wave W1 does not have the wave number component in the x-direction, the lateral refraction does not occur in the electron wave W1.

On the other hand, the electron wave W2 enters into the region under the Schottky electrode 134 obliquely. Thereby, only the y-component of the wave number vector, $k_Y$, experiences the change from $k_Y$ to $k_{Y'}$ while the x-component, $k_X$, remains unchanged. Such a change in the wave number vector corresponds to the change in the velocity of the wave, and the electron wave W2 experiences the refraction as shown in FIG.7 similar to the light wave. The refraction angle θ' is determined by the ratio of the wave number vector $k_{Y'}$ to the wave number vector $k_X$, while the wave number vector $k_{Y'}$ is determined by the control voltage applied to the Schottky electrode 134. Upon exiting from the region under the Schottky electrode 134, the electron wave W2 resumes the original wave number $k_Y$, and the electron wave W2 propagates in a path parallel to the original path but with a lateral offset δ as shown in FIG.7.

It should be noted that the foregoing refraction of the electron wave W2, represented by the relationship between the wave number vectors $k_X$ and $k_Y$, can be represented in terms of the electron density n and n' for the two-dimensional electron gas not located under the Schottky electrode 134 and for the two-dimensional electron gas located under the Schottky electrode 134 as follows.

Referring to FIG.8 showing the three-dimensional wave number vector space $k_X$-$k_Y$-$k_Z$, the state of the two-dimensional electron gas in the X-Y plane is confined in the circle having a radius corresponding to $k_F$ and located coincident to the plane that is characterized by $k_Z = 0$. Assuming the cyclic boundary condition with the size L for each edge in the plane of the circle, the total number N of the electrons in the foregoing circle is represented as

$$N = 2\pi k_F^2 / (2\pi/L)^2. \quad (6)$$

On the other hand, the quantity N is represented by the state density ρ(E) as

$$N = L^2 \int_0^{E_F} \rho(E) \cdot dE \quad (7)$$

From Eqs.(6) and (7), one obtains the relationship

$$L^2 \int_0^{E_F} \rho(E) \cdot dE = 2\pi k_F^2 / (2\pi/L)^2. \quad (8)$$

By differentiating Eq.(8), one obtains the representation for the state density ρ(E) as

$$\rho(E) = m^*/(\pi \hbar^2) \quad (9)$$

where m* represents the effective mass of the electron that is defined as $m^* = \hbar^2/(d^2E/dk^2)$ as is well known.

Using Eq.(8), one obtains the representation of the Fermi energy $E_F$ in terms of the electron density n as

$$E_F = \pi \hbar^2/m^* \cdot n \quad (10)$$

where n is given by $n = N/L^2$.

EP 0 461 867 A2

Obviously, the electron density n is proportional to the area of the circle of FIG.8 and thus to the magnitude of the wave number vector $k_F$ that is defined as

$$k_F{}^2 = k_X{}^2 + k_Y{}^2 \quad (11)$$

When the electron wave having the Fermi energy $E_F$ passes through the region where the potential is modified, the Fermi energy $E_F$ experiences a change to preserve the total energy of the electron wave, and thereby the electron density is changed from n to n' according to the relationship

$$(k_X{}^2 + k_Y{}^2) : (k_X{}^2 + k_{Y'}{}^2) = n : n'. \quad (12)$$

From the simple geometrical relationship shown in FIG.7, the angle of incidence $\theta$ is represented in terms of the wave number vectors $k_X$ and $k_Y$ as

$$\sin\theta = k_X/(k_X{}^2 + k_Y{}^2)^{\frac{1}{2}}. \quad (13)$$

Similarly, the angle of refraction $\theta'$ is represented as

$$\sin\theta' = k_X/(k_X{}^2 + k_{Y'}{}^2)^{\frac{1}{2}}. \quad (14)$$

From Eqs.(13) and (14), one obtains the famous equation of refraction as follows, with the electron density n and n' acting as the refractive index of the medium

$$\sin\theta/\sin\theta' = (n'/n)^{\frac{1}{2}}. \quad (15)$$

Referring to FIG.7, again, the magnitude of the offset $\delta$ is determined geometrically by the incidence angle $\Delta$, refraction angle $\theta'$ and the size Lg of the Schottky electrode 134. Given a diffraction angle $\theta'$, the offset distance $\delta$ increases with increasing size Lg of the electrode 134. On the other hand, the offset $\delta$ can be changed by changing the control voltage even when the size Lg is fixed.

To achieve the on-off operation of the electron wave device, it is necessary to shift or move the electron beam W2 such that the electron beam W2 misses the quantum point contact 132a' or 132b' when the control voltage is applied to the Schottky electrode 134. For this purpose, the width W of the quantum point contacts 132a' and 132b' under the gap 132a and 132b has to be sufficiently smaller than the offset $\delta$ that is caused by the control voltage. Generally, the width W of the gap 132a or 132b is set substantially equal to the width of the gap 128. When the actual size of the quantum point contacts 132a' or 132b' is reduced by applying a control voltage to the Schottky electrodes 130a and 130c, the sensitivity of the device increases. On the other hand, when the size of the quantum point contacts 132a' and 132b' is too small, the energy level of the quantum states formed in the quantum point contacts increases and there appears a risk that the electron wave may be reflected back by the quantum point contacts. In the preferred embodiment, the width W of the gaps 132a and 132b is set generally equal to the width of the gap 128, and the bias voltage similar to the one applied to the Schottky electrodes 126a and 126b is applied to the Schottky electrodes 132a and 132b.

In the case when the electron wave device is to be turned on in the absence of the control voltage applied to the Schottky electrode 134, the distance D of FIG.6 is determined by the equation,

$$D = (t - Lg) \cdot \tan\theta + Lg \cdot \tan\theta. \quad (16)$$

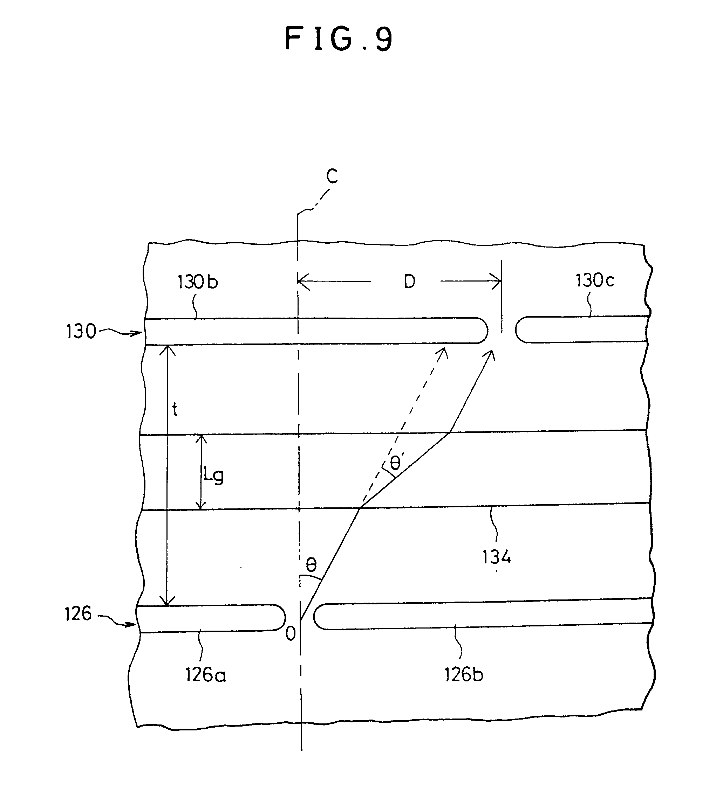

See FIG.9 showing the enlarged view of the structure of FIG.6 for the region including the first and second barrier structures 126 and 130. As the foregoing Eq.(16) is obvious from FIG.9, further description will be omitted.

Next, the operation of the device of FIG.6 will be described.

Referring to FIG.6, the emitter electrode 120 is grounded and a bias voltage $V_{BE}$ of about 30 µV is applied across the emitter electrode 120 and the base electrode 124, and thereby a difference in the potential is induced in the two-dimensional electron gas across the barrier structure 126.

In order to form the quantum point contact, a gate bias voltage $V_1$ of -0.195 volts is applied to the Schottky electrode in view of the result of the previously described experiment, such that the energy $E_F$ of the incident electron wave W2 is located above the quantum level E1 (see FIG.2(B)) formed in the quantum point contact 128 but below the higher quantum levels such as the quantum level E2. Thereby, the electron wave W2 is injected into the side of the barrier 126 where the base electrode 124 is provided and propagates ballistically through the two-dimensional electron gas with the foregoing wave number vectors $k_X$ and $k_Y$.

The electron wave W2 then passes through the region under the Schottky electrode 134 wherein the potential rise $E_{\phi}$ is formed in response to the control voltage $V_g$ applied thereto and experiences the refraction. After passing through the region under the electrode 134, the electron wave W2 passes through the quantum point contact 130a' or 130b' where similar quantum states are formed in response to the gate bias voltage $V_d$ of -0.195 volts, and exits the side where the collector electrode 122 is provided. The collector electrode is biased by a collector voltage $V_{CE}$ of 30 µV. This means that the voltage between the base electrode and the collector electrode is set zero, and no potential difference appears in the two-dimensional electron gas across the barrier structure 130. It should be noted that the electron wave W2 has the energy that is substantially higher than the quantum levels such as $E_0$ or $E_1$, and the electron wave W2 passes through the quantum point contact freely. Typically, the height of the potential $E_{\phi}$ is changed in the range of 0 - 50 meV for the electrode 134 that has the size Lg of 0.1 µm.

11

Next, the process for fabricating the electron device of the first embodiment will be described briefly.

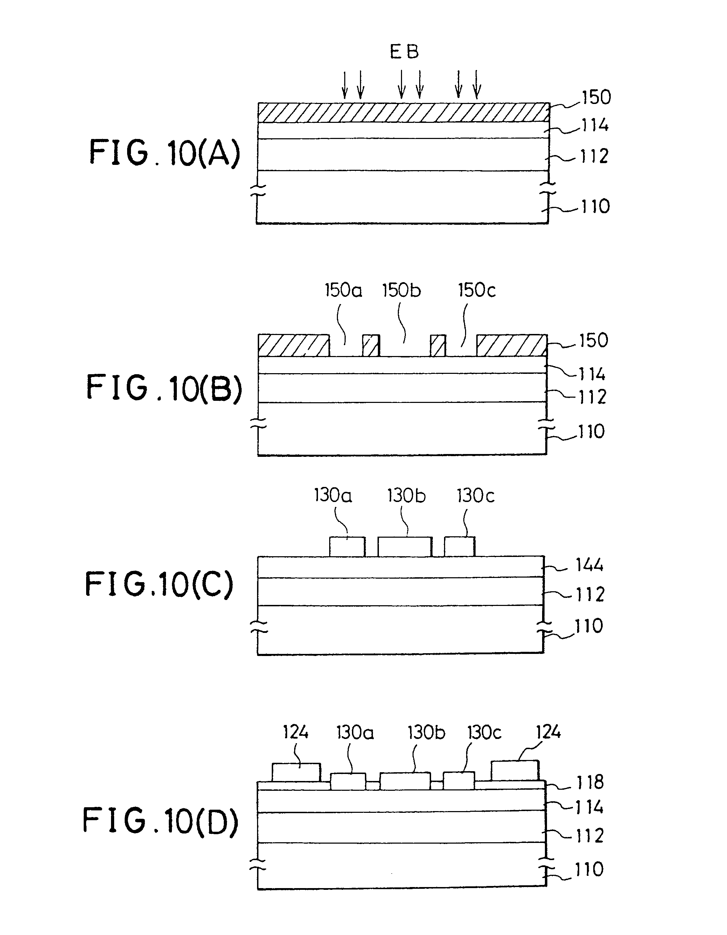

Referring to FIG.10(A) showing the cross section of the device of FIG.4 along the line 5A-5A', an electron beam resist 150 is deposited on the layered semiconductor body that includes the substrate 110, the GaAs active layer 112 and the doped AlGaAs layer 114, and is patterned as shown in FIG.10(B) after exposure by the focused electron beam. Thereby, patterns 150a -150c are formed in the electron beam resist layer 150. It should be noted that similar patterns are formed also in correspondence to the Schottky electrodes 126a, 126, and 134. By using the focused electron beam, one can achieve the patterning with the precision that provides the size d of 0.1 μm and the width W of 0.4 μm as described previously with reference to FIG.4.

Next, in the step of FIG.10(B), the Schottky electrodes 130a, 130b and 130c as well as other Schottky electrodes are formed by consecutively depositing the layers of titanium, platinum and gold and applying the lift-off process subsequently. Thereby, a structure shown in FIG.10(C) is obtained.

Next, the n-type GaAs contact layer 118 is deposited on the structure of FIG.10(C), and the layer 118 is subjected to an etch-back process until the electrodes 130a - 130c are exposed. Further, by providing the ohmic electrodes such as the base electrode 124, the collector electrode 122 and the emitter electrode 120, one obtains the completed structure as shown in FIG.10(D).

In the foregoing first embodiment, it will be noted that the electron wave W1 is not used in the operation of the electron wave device of the first embodiment. In fact, the electron wave W1 is produced together with the electron wave W2 with a substantial power as clearly seen in the result of experiment shown in FIG.3(D) and FIG.3(F). As discussed previously with reference to FIG.2(B), one can induce the electron wave W1 alone by setting the relative energy level of the quantum state E0 and the Fermi energy $E_F$, while the formation of the electron wave W2 alone is generally not possible. Thus, it will be understood that, when the electron wave W1 is used for the on-off operation, one can obtain a more efficient electron wave device that provides an increased output power than the first embodiment device.

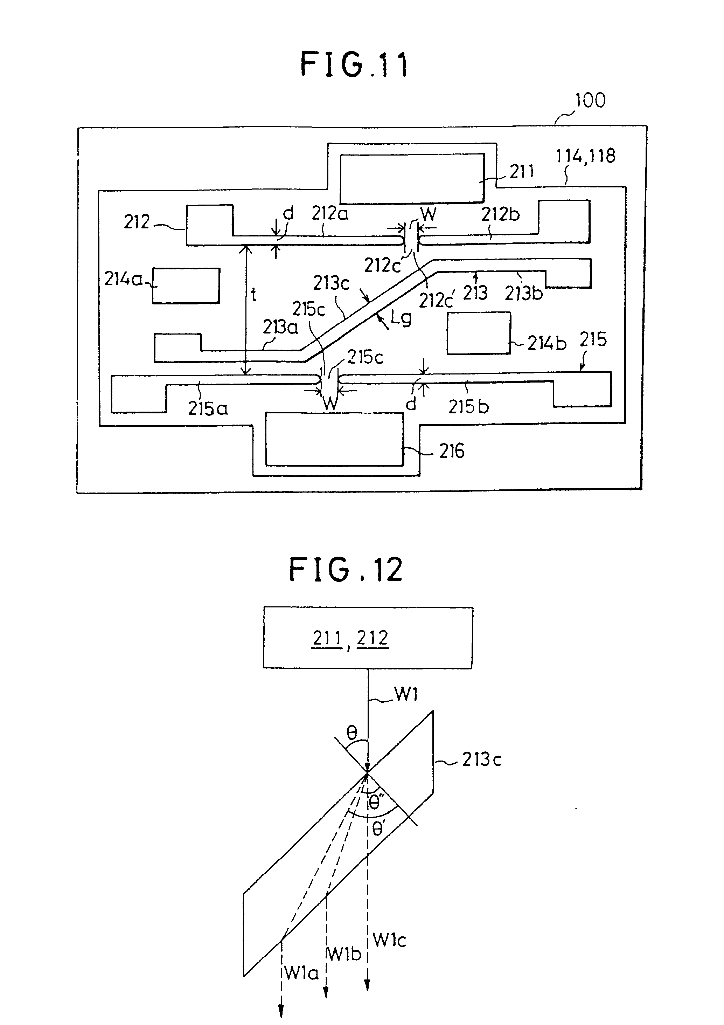

FIG.11 shows a second embodiment of the present invention, wherein the first mode electron wave W1 is used for the operation.

Referring to FIG.11, the electron wave device of the second embodiment is formed on the layered semiconductor body 100 similar to the first embodiment. In the layered semiconductor body 100, an emitter electrode 211 and a collector electrode 216 are provided in ohmic contact to the patterned n-type GaAs contact layer 118, and a pair of mutually opposing barrier structures 212 and 215 are provided to form a Schottky contact to the patterned n-type AlGaAs layer 114 respectively in the vicinity of the emitter electrode 211 and the collector electrode 216. Thereby, the first and second barrier structures 212 and 215 interrupt the flow of the electrons between the emitter and collector electrodes except for gaps 212c and 215c that are formed respectively in the barrier structure 212 and the barrier structure 215.

The first barrier structure 212 comprises a pair of Schottky electrodes 212a and 212b provided directly on the n-type AlGaAs layer 114 with the foregoing gap 212c formed therebetween. Similarly, the second barrier structure 215 comprises a pair of Schottky electrodes 215a and 215b with the foregoing gap 215c formed therebetween. The Schottky electrodes 212a and 212b as well as the Schottky electrodes 215a and 215b are aligned in the x-direction, wherein the first barrier structure 212 and the second barrier structure 215 extend parallel with each other with a mutual distance t of 3 μm. The gap 212c and the gap 215c have a width W that is about 0.2 μm in the narrowest part. Typically, the gaps have a larger width of about 0.4 μm at the outermost part. Thereby, a quantum point contact 212c' is formed in correspondence to the gap 212c and a quantum point contact 215c' is formed in correspondence to the gap 215c. Thereby, the quantum point contact 212c' acts as the injector for injecting the electron waves with predetermined wave number vectors similarly to the case of the quantum point contact 128' of the first embodiment, and the quantum point contact 215c' acts as the detector similar to the quantum point contacts 132a' and 132b' for exiting the electron waves.

Between the first and second barrier structures 212 and 215, a Schottky electrode 213 is provided in contact to the n-type AlGaAs layer 114 such that the electrode 213 extends to traverse the pass of the electron waves that propagates from the quantum point contact 212c' to the quantum point contact 215c'. The Schottky electrode 213 includes a first part 213a provided close to the electrode 215a to extend parallel therewith, a second part 213b provided close to the electrode 212b to extend parallel therewith, and a third part 213c that connects the first part 213a and the third part 213b with an angle of about 45 degrees with respect to the general direction of the first and second barrier structures 212 and 215. The Schottky electrode 213 has a width Lg in correspondence to the part 213c that may be set to 0.3 μm.

Further, in correspondence to the area between the Schottky electrode 212a of the barrier structure 212 and the first part 213a, there is provided a base electrode 214a in ohmic contact to the contact layer 118. Similarly, another base electrode 214b is provided between the electrodes 213b and 215b to form an ohmic contact with the contact layer 118. As the cross section of the structure of FIG.11 is easily derived from the cross section of FIGS.5(A) - 5(C) for the first embodiment, the illustration and further description will be omitted.

FIG.12 shows the principle of the present embodiment. In this embodiment, the first barrier structure 212 is biased to form the electron wave W1 that propagates perpendicularly to the structure 212 while the formation of the electron wave W2 is suppressed. The electron wave W1 thus produced propagates along the path that intersect the electrode part 213c obliquely and experiences the refraction upon passage through the region under the electrode part 213c. Thereby, the electron wave W1a or W1b is formed with the refraction angle $\theta'$ or $\theta''$. When no control voltage is applied to the electrode 213c, the electron wave W1c is formed without refraction as illustrated. According to the present embodiment, one can use the electron wave W1 that has the largest intensity for the switching operation, and an improved S/N ratio is achieved. It should be noted that all the energy of the incident electron wave is used for producing the electron wave W1 when the energetical relationship between the quantum levels in FIG.2(B) and the Fermi energy $E_F$ is set appropriately.

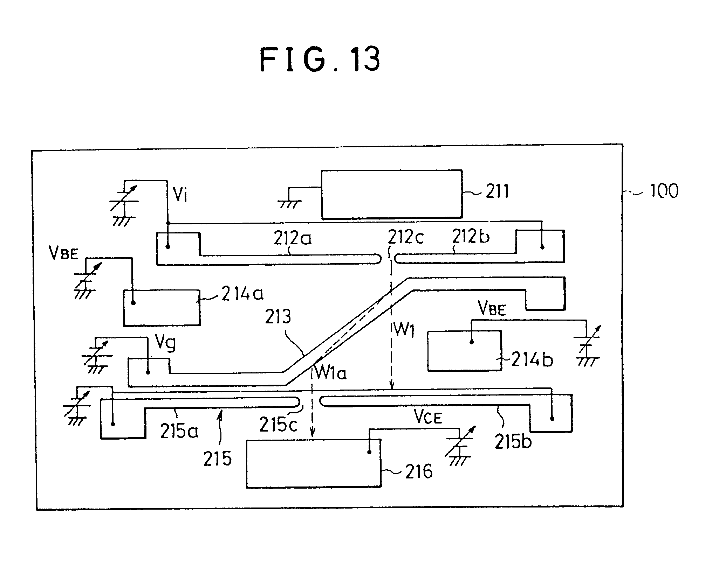

FIG.13 shows the operation of the device of FIG.11.

Referring to FIG.13, the emitter electrode 211 is connected to the ground and a positive collector voltage $V_{CE}$ is applied to the collector electrode 216. Further, a negative bias voltage $V_l$ is applied to the Schottky electrodes 212a and 212b, a negative bias voltage $V_d$ applied to the Schottky electrodes 215a and 215b, a positive base voltage $V_{BE}$ applied to the base electrode 214a. Further, a negative control voltage $V_g$ is applied to the Schottky electrode 213. Thereby, the electron wave W1 for the ground mode is produced by the quantum point contact under the gap 212c and experiences the refraction by the Schottky electrode 213. The electron wave W1 thus refracted exits to the collector electrode 216 through the quantum point contact formed under the gap 215c as the electron wave W1a. In the unbiased state of the Schottky electrode 213, on the other hand, the electron wave W1 proceeds straight and misses the quantum point contact formed under the gap 215c. Thereby no output is obtained at the collector electrode 216. The electrons that have missed the exit quantum point contact are absorbed by the base electrode 214b.

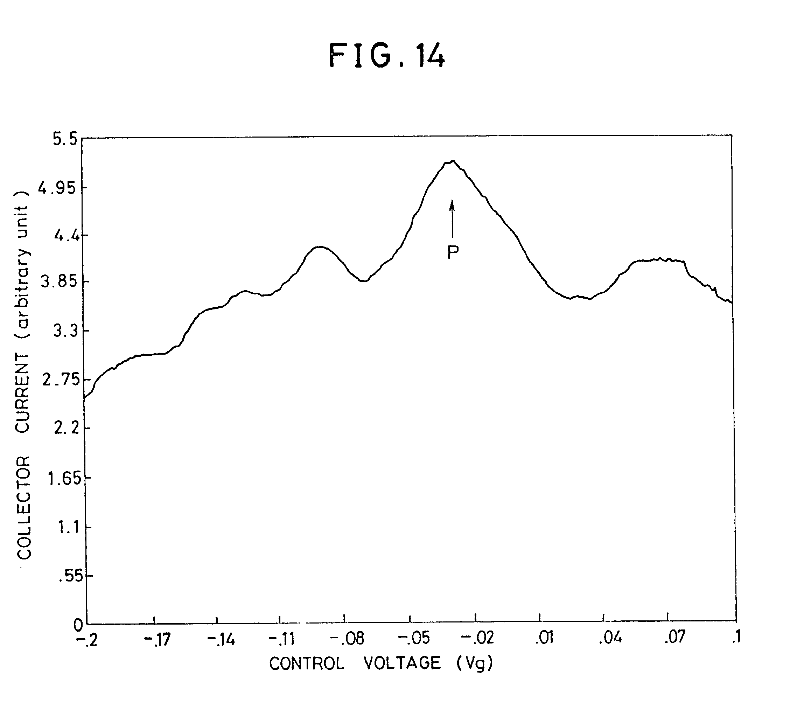

FIG.14 shows the result of the experiment conducted on the device of FIG.13 for various control voltages $V_g$, with the collector voltage $V_{CE}$ set to 10 μV, the base voltage $V_{BE}$ set to 10 μV, the gate bias voltage $V_l$ set to -0.93 volts and the gate bias voltage $V_d$ set to -1.42 volts. The width W of the gap 212c was set to 1.7 μm as described previously and the experiment was conducted at 0.3 °K. This experiment clearly shows the presence of the peak P corresponding to the control voltage $V_g$ of -0.3 volts. Thereby, the detection of the refracted electron beam W1 is clearly demonstrated.

In operation, the first barrier structure 212 is biased such that the Fermi energy $E_F$ of the electrons injected by the emitter electrode 211 is located between the ground state $E_0$ and the first quantum state $E_1$. Thereby, the electron wave for the mode W1 alone is formed at the quantum point contact 212c' and the electron wave W1 thus formed experiences the refraction by the potential that is formed by the Schottky electrode 213. The second barrier structure 215 is also biased such that a desirable sensitivity is achieved by suitably narrowing the size of the quantum point contact. As already described, in the present example, the voltage of -0.93 volts is applied to the Schottky electrodes forming the first barrier structure 212 while the voltage of -1.42 volts is applied to the Schottky electrodes forming the second barrier structure 215. Similar to the case of the first embodiment, there appears a difference in the level of the two-dimensional electron gas across the first barrier structure and across the second barrier structure due to the emitter-base and base-collector bias voltage. Generally, the voltage $V_g$ to the Schottky electrode 213 is set to the range between 0.5 - 1 volt.

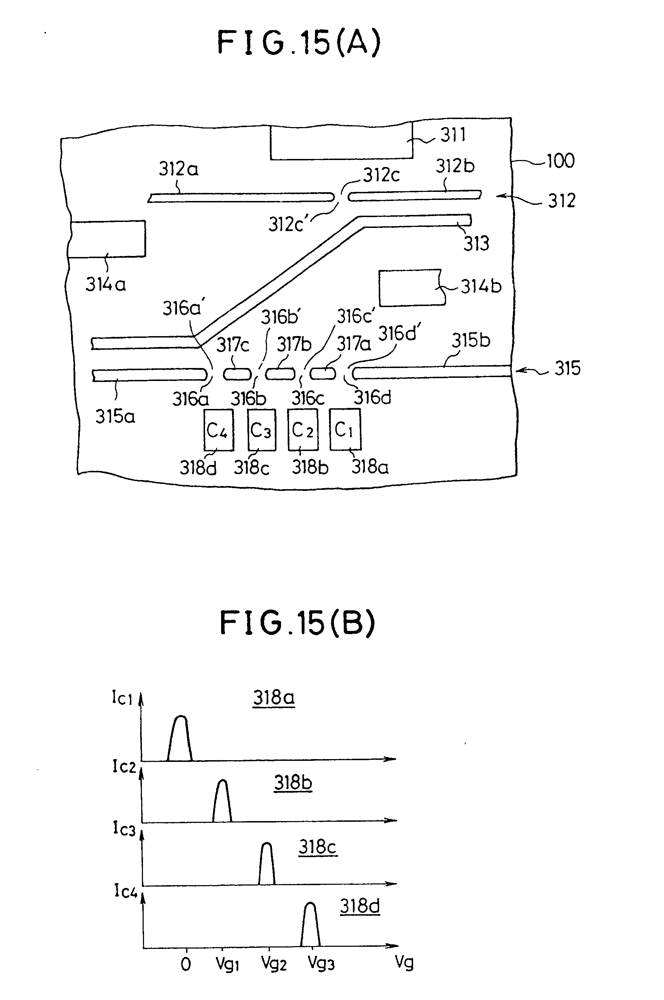

Next, a third embodiment of the present invention will be described with reference to FIGS.15(A) and 15(B). In the present embodiment, the layered semiconductor body 100 on which the electron wave device is formed, has the structure substantially identical with those described previously with reference to FIGS.5(A) - 5(C), and the description thereof with reference to the cross-section will be omitted.

Referring to FIG.15(A) showing the plan view of the device, an emitter electrode 311 corresponding to the emitter electrode 211 is provided on the upper major surface of the contact layer 114 forming the layered semiconductor body 100, and a first barrier structure 312 corresponding to the first barrier structure 212 of the second embodiment is provided to interrupt the flow of electrons injected from the emitter electrode 311 into the two-dimensional electron gas. Similar to the first and second embodiments, the first barrier structure includes a pair of Schottky electrodes 312a and 312b that form the Schottky contact with the n-type AlGaAs layer 112 located underneath the contact layer 114, with a gap 312c formed therebetween. Thereby, a quantum point contact 312c' is formed under the gap 312c in correspondence to the two-dimensional electron gas similar to the foregoing embodiments.

At the side of the first barrier structure 312 away from the emitter electrode 311, there is provided a Schottky electrode 313 corresponding to the Schottky electrode 213 for causing the refraction of the electron waves emitted from the quantum point contact formed under the gap 312c. Further, in order to cause the injection of the electrons into the quantum point contact 312c' to form the electron wave W1, base electrodes 314a and 314b are provided in ohmic contact with the contact layer 118 similar to the base electrodes 214a, 214b of the second embodiment.

In the present embodiment, a second barrier structure 315 provided in correspondence to the second barrier structure 215 is formed from a pair of Schottky electrodes 315a and 315b as well as a plurality of Schottky electrode segments 317a - 317c provided between the electrodes 315a and 315b. Thereby, a plurality of gaps 316a - 316d are formed between these Schottky electrodes, and a plurality of collector electrodes 318a - 318d are provided on the upper major surface of the contact layer 118 in correspondence to the gaps 316a - 316d. In correspondence to the plurality of gaps 316a - 316d, there are formed a plurality of quantum point contacts 316a' - 316d' as illustrated.

Next, the operation of the device of FIG.15(A) will be described.

In this embodiment, the Schottky electrodes forming the first and second barrier structures 312 and 315 are biased similarly to the case of the second embodiment, and the control voltage $V_g$ to the electrode 313 is changed. Thereby, the electron wave W1 is refracted by the potential induced by the electrode 313 similarly to the previous embodiments, and the collector electrodes 318a - 318d detect the collector current $I_{c1}$ - $I_{c4}$ as shown in FIG.15(B).

It should be noted that the collector electrodes 318a - 318d detect the collector current in response to the respective control voltages that differ in each collector electrode. For example, when there is no control voltage $V_g$ applied to the electrode 313, the electron wave W1 produced at the quantum point contact formed under the gap 312c proceeds straight and detected by the collector electrode 318a as the collector current $I_{c1}$. On the other hand, when the control voltage $V_g$ is increased to $V_{g1}$, the electron wave W1 is refracted and detected by the collector electrode 318b as the collector current $I_{c2}$, after passing through the quantum point contact formed under the gap 316c in the second barrier structure 315. Similarly, when the control voltage $V_g$ is increased to $V_{g2}$, the collector electrode 318c detects the current as the collector current $I_{c3}$. Further, when the control voltage $V_g$ is increased to $V_{g3}$, the collector electrode 318d detects the current $I_{c3}$. Thereby, the device of the third embodiment operates as a high-speed selector switch. Such a device may be used for high-speed analog-to-digital conversion when an input analog signal is used for the control voltage $V_g$. Obviously, the number of gaps formed in the second barrier structure 315 is not limited to four.

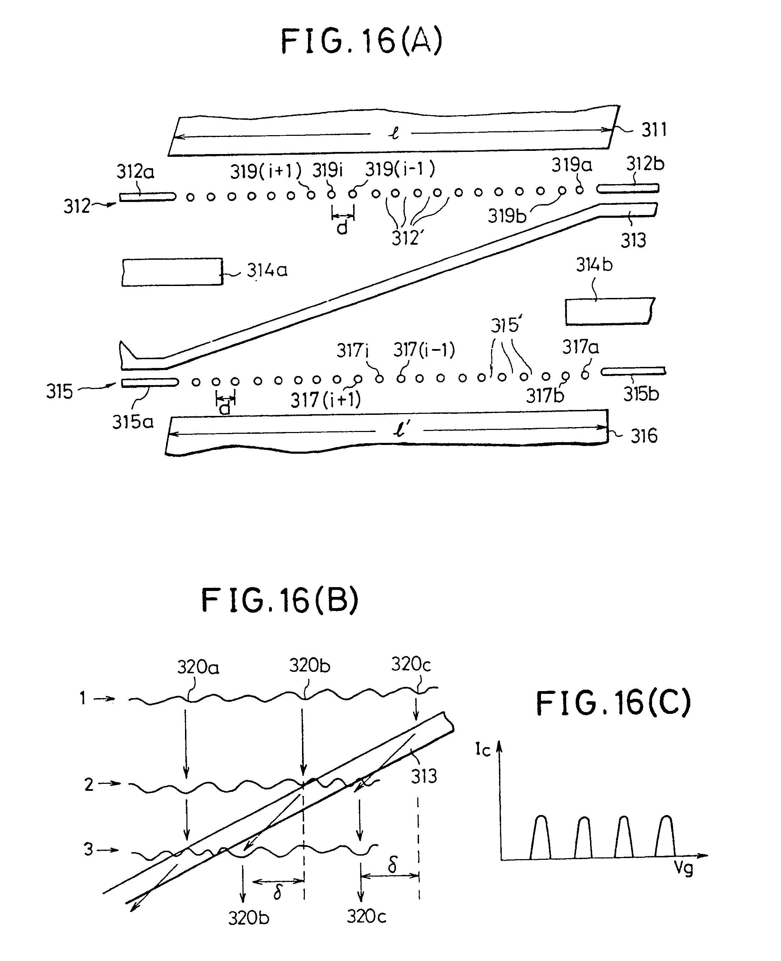

FIGS.16(A) and 16(B) show a fourth embodiment of the present invention. In the drawings, those parts that correspond to the parts described previously with reference to the preceding drawings are designated by the same reference numerals and the description will be omitted.

In the present embodiment, the first barrier structure 312 includes a number of Schottky electrode segments 319a, 319b . . . 319(i+1) provided between the Schottky electrodes 312a and 312b with a separation d. Thereby, a number of quantum point contacts 312' are formed in correspondence to the gaps formed between the Schottky electrodes in the barrier structure 312. In correspondence to the first barrier structure 312, the second barrier structure 315 of the present embodiment also includes a number of Schottky electrode segments 317a, 317b . . . 317(i+1) with the same separation d. Thereby, a number of quantum point contacts 315' are formed in correspondence to the gaps between the Schottky electrodes forming the second barrier structure 315. The emitter and collector electrodes 311 and 315 have the widths 1 and 1' that are set sufficient to inject the electrons to each of the quantum point contacts formed under the first barrier structure 312 or sufficient to collect the electrons that have passed through the quantum point contacts under the second barrier structure 315.

In such a structure, a number of electron waves all in the mode W1 are emitted from the quantum point contacts 312' formed under the first barrier structure 312. These electron waves are synchronized in phase and there is established a pseudo-planar electron wave traveling straight to the collector electrode 316. Each electron wave W1 forming the pseudo-planar electron wave is refracted by the electrode 313, and thereby a number of electron waves or electron rays are deflected parallel.

FIG.16(B) shows the refraction of the pseudo-planar electron wave formed in the device of FIG.16(A).

Referring to FIG.16(B), the pseudo-planar electron wave has the wave-front moving along the positions 1, 2, 3 . . . while the planar electron wave is formed from a number of rays 320a. 320b, 320c,. . . emitted from respective quantum point contacts formed in the first barrier structure 312. There, the ray 320c enters the region under the electrode 313 first and experiences the refraction. After refraction, the ray 320c exits in the direction coincident to the original direction but with a lateral shift $\delta$ as illustrated. While the ray 320c is exiting from the region under the electrode 313, the ray 320b enters into the region under the electrode 313 and experiences the refraction similar to the ray 320c. Upon exiting, the ray 320b resumes the original propagating direction but with a lateral shift identical with the distance $\delta$. In other words, the rays 320b and 320c propagate parallel in the original propagating direction after refraction, with the lateral shift $\delta$ with respect to the original path. Exactly the same refraction occurs in the ray 320a.

Now, when the pseudo-planar electron wave enters into the second barrier structure 315 after the foregoing refraction, the planar electron wave will be reflected when the component rays 320a, 320b,. . . hit the depletion region formed immediately under the Schottky segment electrodes 317a - 317(i+1). On the other hand, when the amount of shift δ agrees with the distance d, each ray hits the quantum point contact formed between the Schottky electrode segments and passes therethrough. Thereby, an output characteristic shown in FIG.16(C) is obtained wherein the collector current $I_C$ is detected in response to a plurality of discrete control voltages $V_g$. According to the present embodiment, one can increase the output current that is detected by the collector electrode 316.

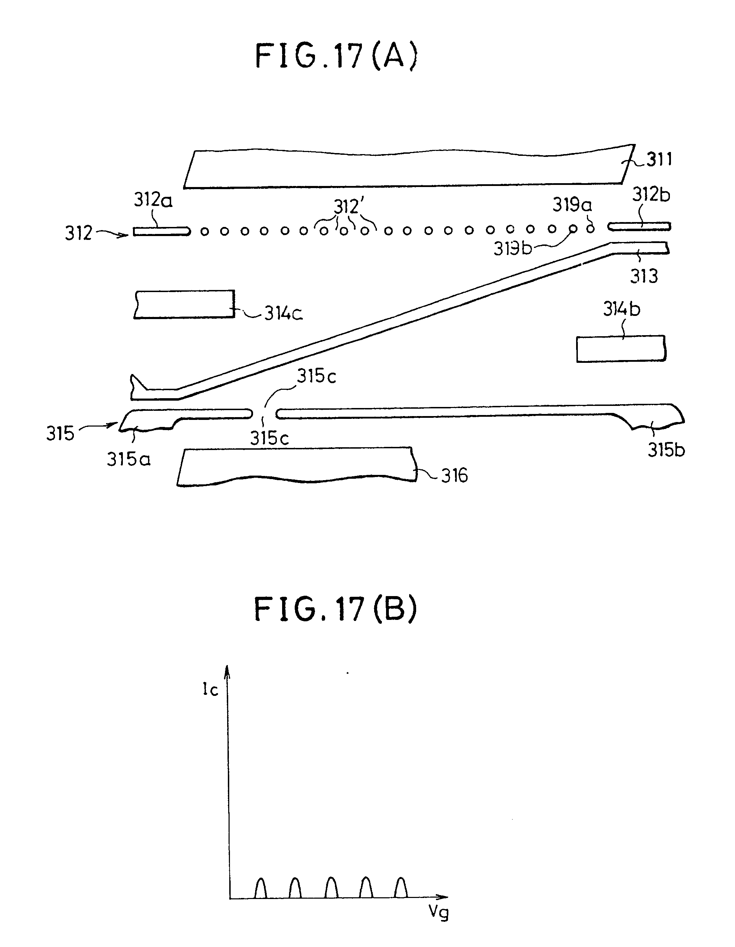

FIG.17(A) shows a fifth embodiment of the present invention. Similar to the foregoing embodiment, the parts that correspond to those described previously are designated with the same reference numerals and the description thereof will be omitted.

In the present embodiment, the first barrier structure 312 is configured similar to the case of the previous embodiment in that the electrode 312 includes a number of Schottky electrode segments 319a, 319b,... between the Schottky electrodes 312a and 312b. Thereby, a number of quantum point contacts are formed under the gaps formed between adjacent Schottky electrode segments. On the other hand, the second barrier structure 315 is formed from the Schottky electrodes 315a and 315b with a single gap 315c formed therebetween. In correspondence to the gap 315c, a quantum point contact 315c′ is formed similar to the first and second embodiments.

In the present embodiment, a pseudo-planar electron wave similar to the pseudo-planar electron wave of the previous embodiment is formed from a number of rays emitted from a number of quantum point contacts that are formed under the first barrier structure 312, and one of these rays hits the quantum point contact 315c′ after refraction caused by the electrode 313. Particularly, by increasing the control voltage $V_g$ successively, the rays of electron wave hits one after another the quantum point contact 315c′ and an output characteristic shown in FIG.17(B) is obtained.

Further, the present invention is not limited to the embodiments described heretofore, but various variations and modifications may be made without departing from the scope of the invention.

## Claims

1. A quantum wave device for switching a flow of carriers formed therein in response to a control voltage signal, comprising: a medium (100) for transporting carriers in the form of a two-dimensional carrier gas confined in a plane; emitter electrode means (120, 211) provided on the medium for injecting the carriers into the two-dimensional carrier gas; and collector electrode means (122, 216) provided on the medium for collecting the carriers from the emitter electrode means along the two-dimensional carrier gas; characterized by

   a first quantum point contact (128′, 212c′) provided on the medium between the emitter electrode means and the collector electrode means for passing the carriers therethrough in the form of a quantum mechanical wave in a predetermined direction, said first quantum point contact being characterized by a size (L), measured along a path of the carriers therethrough, that is approximately equal to or smaller than any of the elastic and inelastic scattering length of the carriers in the two-dimensional carrier gas;

   a second quantum point contact (132a′, 132b′, 215c′) provided on the medium between the first quantum point contact and the collector electrode means for passing the carriers therethrough in the form of a quantum mechanical wave, said second quantum point contact being characterized by a size (L), measured along a path of the carriers therethrough, that is approximately equal to or smaller than any of the elastic and inelastic scattering length of the carriers in the two-dimensional carrier gas; and

   refraction means (134, 213) provided on the medium between the first point contact and the second point contact, said refraction means being applied with the control voltage signal and refracting the quantum mechanical wave of the carrier produced by the first quantum point contact in response to the control voltage signal such that the quantum mechanical wave hits the second quantum point contact when the control voltage assumes a first voltage level and such that the quantum mechanical wave misses the second quantum point contact when the control voltage assumes a second voltage level different from the first voltage level.

2. A quantum wave device as claimed in claim 1 characterized in that said quantum wave device further comprises: first barrier means (126, 212) provided on the medium (100) between the emitter electrode means and the collector electrode means, said first barrier means rejecting the carriers therefrom and provided to interrupt the two-dimensional carrier gas such that the flow of the carriers from the emitter electrode means to the collector electrode means along the two-dimensional gas is discontinued in correspondence the first barrier means; and second barrier means (130, 215) provided on the medium (100) between the first barrier means and the collector electrode means with a separation from the first barrier means, said second barrier means rejecting the carriers to penetrate therein and provided to interrupt the two-dimensional carrier gas such that the flow of the carriers from the emitter electrode means to the collector electrode means along the two-dimensional carrier gas is discontinued in correspondence the second barrier means; said first and second barrier means (126, 130; 212, 215) extending substantially parallel with each other when viewed in a direction perpendicular to the plane of the two-dimensional carrier gas, wherein said first quantum point contact is formed in the first barrier structure, and said second quantum point contact is formed in the second barrier structure.

3. A quantum wave device as claimed in claim 2 characterized in that said refraction means (134) extend substantially parallel with the first and second barrier means (126, 130) when viewed perpendicularly to the plane of the two-dimensional carrier gas.

4. A quantum wave device as claimed in claim 3 characterized in that said second barrier means (130) includes a pair of said second quantum point contacts (132a', 132b') with an equal distance to the first quantum point contact (128').

5. A quantum wave device as claimed in claim 2 characterized in that said refraction means (213c) has at least an edge (213-2) defining a boundary of the refraction means such that the edge extends obliquely to the first and second barrier means (213, 215) when viewed perpendicularly to the plane of the two-dimensional carrier gas.

6. A quantum wave device as claimed in claim 5 characterized in that said refraction means (213) includes a part (213c) that extends obliquely to the first and second barrier means when viewed perpendicularly to the plane of the two-dimensional carrier gas.

7. A quantum wave device as claimed in claim 5 characterized in that said first barrier means (312) includes a plural number of said first quantum point contacts (312').

8. A quantum wave device as claimed in claim 5 characterized in that said second barrier means (315) includes a plural number of said second quantum point contacts (315').

9. A quantum wave device as claimed in claimed 5 characterized in that said first barrier means (312) includes said first quantum point contact (312c') with the number of one, while said second barrier means includes said second quantum point contact with a plural number.

10. A quantum wave device as claimed in claim 5 characterized in that said first barrier means (312) includes said first quantum point contact (312') with a plural number, while said second barrier means (315) includes said second quantum point contact (315') with a plural number.

11. A quantum wave device as claimed in claim 1 characterized in that said medium (100) comprises a layered semiconductor body that in turn comprises an undoped first layer (112) of a first semiconductor material having a first electron affinity, said first layer having an upper major surface and a lower major surface, and a doped second layer (114) of a second semiconductor material having a second electron affinity that is smaller than the first electron affinity, said second layer having an upper major surface and a lower major surface and provided on the upper major surface of the first layer, said first and second layers forming the two-dimensional carrier gas in the first layer along the upper major surface thereof.

12. A quantum wave device as claimed in claim 11 characterized in that each of said emitter and collector electrode means (120, 122) forms an ohmic contact with the upper major surface of the second layer.

13. A quantum wave device as claimed in claim 11 characterized in that said quantum wave device comprises comprises a pair of elongated Schottky electrodes (126a, 126b) provided on the upper major surface of the first layer in Schottky contact therewith, said pair of elongated Schottky electrodes being aligned on a line with a gap (128) formed therebetween in correspondence to the first quantum point contact (128'), said quantum wave device further comprises a plurality of elongated Schottky electrodes (130a, 130b, 130c) provided on the upper major surface of the first layer in Schottky contact therewith, said plurality of elongated Schottky electrodes being aligned on a line with gaps (132a, 132b) formed therebetween in correspondence to the second quantum point contact (132a', 132b').

**14.** A quantum wave device as claimed in claim 11 characterized in that said refraction means (134, 213) comprises an elongated Schottky electrode provided on the upper major surface of the second layer to form a Schottky contact therewith for inducing a potential change in response to the control voltage signal.

**15.** A quantum wave device as claimed in claim 11 characterized in that said quantum wave device further comprises base electrode means (124) provided on the upper major surface of the second layer (114) in ohmic contact therewith in correspondence to a part located between the first and second barrier means (126, 130).

**16.** A logic device for performing a logic operation, characterized by:

a medium (100) for transporting carriers in the form of a two-dimensional carrier gas confined in a plane; emitter electrode means (311) provided on the medium for injecting the carriers into the two-dimensional carrier gas;

a plurality of collector electrode means (318a - 318d) provided on the medium with a separation from each other and with a separation from the emitter electrode means, for collecting the carriers from the two-dimensional carrier gas; said emitter electrode means and collector electrode means causing the flow of the carriers from the emitter electrode means to the collector electrode means along the two-dimensional carrier gas;

first barrier means (312) provided on the medium between the emitter electrode means and the collector electrode means, said first barrier means rejecting the carriers therefrom and provided to interrupt the two-dimensional carrier gas such that the flow of the carriers from the emitter electrode means to the collector electrode means along the two-dimensional gas is discontinued in correspondence the first barrier means;

second barrier means (315) provided on the medium between the first barrier means and the collector electrode means with a separation from the first barrier means, said second barrier means rejecting the carriers to penetrate therein and provided to interrupt the two-dimensional carrier gas such that the flow of the carriers from the emitter electrode means to the collector electrode means along the two-dimensional carrier gas is discontinued in correspondence the second barrier means;

a first quantum point contact (312c') provided in the first barrier means for passing the carriers therethrough in the form of a quantum mechanical wave, said first quantum point contact forming a quantum well structure characterized by a plurality of discrete quantum levels in the first barrier means and injecting the carriers as the quantum mechanical wave in a predetermined direction, said first quantum point contact being further characterized by a size, measured along a path of the carriers therethrough, that is approximately equal to or smaller than any of the elastic and inelastic scattering length of the carriers in the two-dimensional carrier gas;

a plurality of second quantum point contacts (316a' - 316d') provided in the second barrier means in correspondence to the plurality of collector electrodes for passing the carriers therethrough in the form of a quantum mechanical wave, each of said second quantum point contact forming a quantum well structure characterized by a plurality of discrete quantum levels in the second barrier means, said second quantum point contact being characterized by a size, measured along a path of the carriers therethrough, that is approximately equal to or smaller than any of the elastic and inelastic scattering length of the carriers in the two-dimensional carrier gas; and

refraction means (313) provided on the medium between the first barrier means and the second barrier means to intercept the quantum mechanical wave of the carrier produced by the first quantum point contact, said refraction means being applied with an input voltage signal and refracting the quantum mechanical wave of the carrier in response to the input voltage signal such that the quantum mechanical wave hits one of said plurality of second quantum point contacts when the input voltage signal assumes a voltage level selected from a plurality of predetermined voltage levels and such that the quantum mechanical wave misses the second quantum point contacts when the input voltage signal assumes a level other than those plurality of predetermined voltage levels,

said plurality of collector electrode means being disposed such that each collector electrode collects the carriers that have passes through the corresponding second quantum point contact in the form of quantum mechanical wave.

FIG.1(A)
PRIOR ART

FIG.1(B)
PRIOR ART

FIG.1(C)
PRIOR ART

FIG.2(A)

FIG.2(C)

# FIG.2(B)

<u>28</u>

$E_F$

$E_1$    $\gamma_1$

$E_F'$

$\gamma_0$

$E_0$

$\longleftarrow$ W $\longrightarrow$

# FIG.2(D)

$K_F'$     $K_F$

$E_0$

$E_C$

<u>34</u>

20

FIG.3 A

# FIG. 3(B)

EP 0 461 867 A2

FIG.3(C)

FIG.3(D)

One mode
90 nm

Two modes
150 nm

Calculated intensity ( arb. units )

Magnetic field ( T )

EP 0 461 867 A2

DIFFRACTION ANGLE (θ)

FIG.3(E)

FIG.3(F)

Transfer efficiency (arb. units)

One mode (-0.28V)

$P_0$

$P_{-1}$

$P_1$

Two modes ( 0.195V)

Magnetic field (T)

# FIG.3(G)

0.35K
$V_{EB} < 30\mu V$

3 ( 2e²/h )

2 ( 2e²/h )

1(2e²/h)

Conductance (mS)

Gate voltage (V)

EP 0 461 867 A2

# FIG.4

EP 0 461 867 A2

FIG. 5(A)

FIG. 5(B)

FIG. 5(C)

# FIG. 6

EP 0 461 867 A2

EP 0 461 867 A2

# FIG. 7

# FIG. 8

29

# FIG.9

E B

FIG.10(A)

150
114
112
110

150a 150b 150c

FIG.10(B)

150
114
112
110

130a 130b 130c

FIG.10(C)

144
112
110

124 130a 130b 130c 124

FIG.10(D)

118
114
112
110

EP 0 461 867 A2

# FIG.11

# FIG.12

FIG. 13

# FIG. 14

# F I G .15(A)

# F I G .15(B)

FIG.16(A)

FIG.16(B)

FIG.16(C)

# FIG.17(A)

# FIG.17(B)